(19) **Europäisches Patentamt / European Patent Office / Office européen des brevets**

(11) **EP 4 625 821 A1**

(12) **EUROPEAN PATENT APPLICATION**

(43) Date of publication:
01.10.2025 Bulletin 2025/40

(21) Application number: 25163985.2

(22) Date of filing: 14.03.2025

(51) International Patent Classification (IPC):
H03K 19/003 (2006.01)    G01R 31/28 (2006.01)
G04F 10/00 (2006.01)

(52) Cooperative Patent Classification (CPC):
H03K 19/00384; G01R 31/2856; G04F 10/005

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 29.03.2024 US 202418621784

(71) Applicant: INTEL Corporation
Santa Clara, CA 95054 (US)

(72) Inventors:
• KRETZSCHMAR, Florian
81545 Munich (DE)
• REGER, Christian
83059 Kolbermoor (DE)
• HEISS, Leonhard
83626 Valley BY (DE)
• AVNI, Shlomo
25210 Ein Hamifratz HA (IL)
• PRASAD S, Siva
695006 Trivandrum (IN)
• JOSE, Jeffin
670645 Mananthavady (IN)
• TOKUNAGA, Carlos
Hillsboro, OR 97124 (US)
• TSCHANZ, James W.
Portland, OR 97229 (US)
• LE, Minh
North Plains, OR 97133 (US)
• BUSTAN, Yuval
40695 Moshav Mismeret (IL)
• RAJCHERT, Eli
2623001 Kiryat Mozkin (IL)

(74) Representative: HGF
HGF Limited
1 City Walk
Leeds LS11 9DX (GB)

(54) **DIGITAL AGING SENSOR**

(57) Some embodiments include an apparatus having a circuit, the circuit including an output node to provide a signal; a first delay line including an input node coupled to the output node of the circuit, and an output node; a second delay line including an input node coupled to the output node of the circuit, and an output node; and time-to-digital converter (TDC) including a first input node coupled to the output node of the first delay line, and a second input node coupled to the output node of the second delay line.

FIG. 1A

**Description**

**Background**

Some electronic systems (e.g., cellular phones, computers, and internet of things [IoT]) have an aging sensor (circuitry) that can operate to track aging induced signal degradation of a selected circuit path (e.g., critical path) in the component of the electric items. The aging sensor can perform sensing operations to provide aging information that can be used by the system to adjust operating parameters (e.g., operating voltage, signal frequency, etc.) in the system. Some conventional aging sensor solutions operate to provide aging information based on measurement of the change (shift) in the frequency of the signal. Such measurement may not provide an accurate aging induced signal degradation of the circuit path that the aging sensor is designed to track.

**Brief Description of the Drawings**

FIG. 1A shows an apparatus 100 including a digital aging sensor 101, according to some embodiments described herein.

FIG. 1B shows an example of time delay of rising edges of the signals of the digital aging sensor of FIG. 1A, according to some embodiments described herein.

FIG. 1C shows an example of time delay of falling edges of the signals of the digital aging sensor of FIG. 1A, according to some embodiments described herein.

FIG. 2 shows a top view (e.g., layout) of a structure of the digital aging sensor of FIG. 1A including the structures of delay lines and TDC, according to some embodiments described herein.

FIG. 3 shows example propagation paths through the delay lines of the digital aging sensor of FIG. 2, according to some embodiments described herein.

FIG. 4A, FIG. 4B, and FIG. 4C show schematic diagrams of delay cells of a reference delay line of digital aging sensor of FIG. 3, according to some embodiments described herein.

FIG. 4D, FIG. 4E, and FIG. 4F shows schematic diagrams of delay cells of an aged delay line of the digital aging sensor of FIG. 3, according to some embodiments described herein.

FIG. 5A shows more details of the propagation path of FIG. 3 at some of the delay cells of the reference delay line of the digital aging sensor FIG. 2, according to some embodiments described herein.

FIG. 5B shows more details of the propagation path of FIG. 3 at some of the delay cells of the aged delay line of the digital aging sensor of FIG. 2, according to some embodiments described herein.

FIG. 6 shows a schematic diagram logic circuitry of the digital aging sensor of FIG. 1A, according to some embodiments described herein.

FIG. 7A shows a schematic diagram of a TDC of the digital aging sensor FIG. 1A, according to some embodiments described herein.

FIG. 7B is a chart showing example values for information generated by the TDC of FIG. 7A, according to some embodiments described herein.

FIG. 7C shows a top view of (e.g., layout) of the structure of the TDC of FIG. 7A, according to some embodiments described herein.

FIG. 8 shows a schematic diagram of an alternative TDC, according to some embodiments described herein.

FIG. 9 shows a schematic diagram of a TDC including self-centering logic feature, according to some embodiments described herein.

FIG. 10 is a flowchart showing an example method of a delay line calibration for the digital aging sensor of FIG. 1A, according to some embodiments described herein.

FIG. 11 is a flowchart showing an example method of a time-zero calibration for the digital aging sensor of FIG. 1A, according to some embodiments described herein.

FIG. 12 is a flowchart showing an example method of another calibration for the digital aging sensor of FIG. 1A, according to some embodiments described herein.

FIG. 13 is a flowchart showing an example method of operating an apparatus, according to some embodiments described herein.

FIG. 14 is a flowchart showing an example method of forming an apparatus, according to some embodiments described herein.

FIG. 15 shows an apparatus in the form of a system, according to some embodiments described herein.

**Detailed Description**

The techniques described herein involve a digital aging sensor that can operate to provide information indicative of delay degradation of a circuit path in part of an electronic component (e.g., an integrated circuit) of an electronic system. In an example, the described digital aging sensor measures the delay difference between an unaged reference delay path and an aged delay path. The aged delay path can be configured to mimic a selected (e.g., critical) path of the electronic component. Measuring information associated with delay degradation is accumulated in the sensor. Therefore, the sensor may not need a storage element (e.g., non-volatile memory) to keep track of aging information.

The described digital aging sensor has a relatively high aging resolution across a wide temperature, voltage and frequency range while maintaining a very small footprint, enabling placement of the sensor in selected (e.g., critical) area of an electronic device. The sensor measures rising and falling edge signal slowdown separately using a small form factor time-to digital converter (TDC) and captures the worst-case aging. The sensor also includes self-centering calibration logic through a TDC and ring-oscillator modes for high volume manufacturing (HVM) calibration.

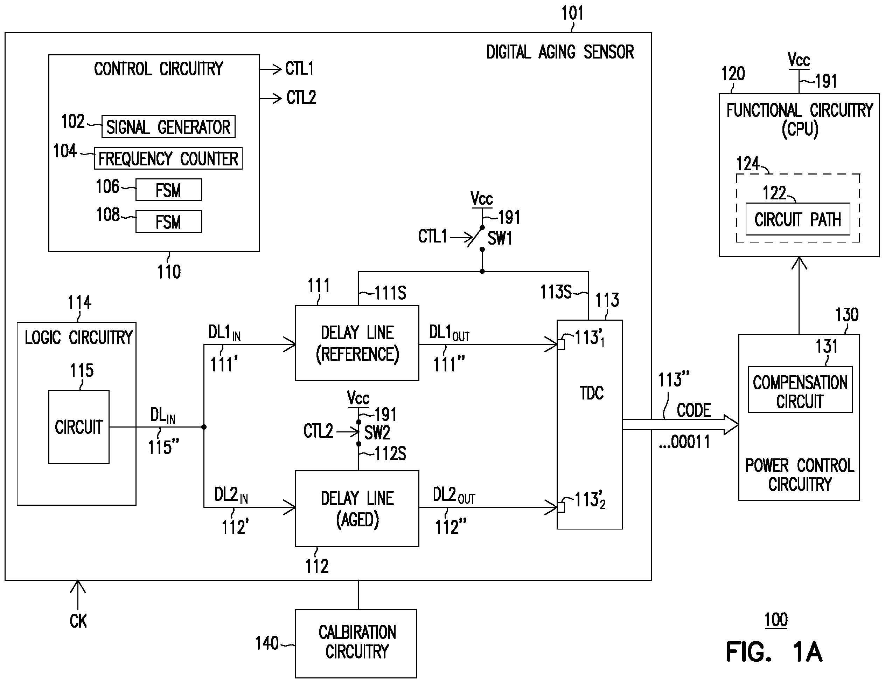

The described aging sensor features improved aging resolution through combination of several features. It offers re-calibration of the TDC unit delay at each system operating point during measurement. It mitigates external disturbance through clock jitter by clock-independent (asynchronous) implementation. Sensing operation of the aging sensor is more accurate (e.g., by not overestimating aging) by factoring-in the actual activity pattern of the circuit path that the sensor is designed to track. The described aging sensor can measure aging induced signal-speedup though a self-centering TDC. The described aging sensor can be configured with different delay path topologies to capture clock path aging and signal path aging separately and it can track aging of different circuit elements. These and other improvements and benefits of the described techniques are discussed in more detail below with reference to FIG. 1A through FIG. 6.

FIG. 1A shows an apparatus 100 including a digital aging sensor 101, according to some embodiments described herein. Apparatus 100 can include or be included in an electronic device or system, such as a computer (e.g., desktop, laptop, or notebook), a tablet, a cellular phone, a system on chip (SoC), a system in a package (SiP), or other electronic devices or systems.

As shown in FIG. 1A, besides digital aging sensor 101, apparatus 100 can include functional circuitry 120, and power control circuitry 130 (which can include a compensation circuit 131), and calibration circuitry 140. FIG. 1A shows an example where compensation circuit 131 is part of power control circuitry 130. However, at least part of compensation circuit 131 (e.g., the entire compensation circuit 131 or a portion of compensation circuit 131) can be part of functional circuitry 120 or other components in apparatus 100.

Functional circuitry 120 can include circuitry that can perform functionality of at least a portion of apparatus 100. For example, functional circuitry 120 can include circuitry of a central processing unit (CPU), a graphics processing unit (GPU), a memory device, or other types of functional circuitries. As shown in FIG. 1A, functional circuitry 120 can include a circuit path 122 (symbolically shown as a box for simplicity) located in a circuit portion 124 of functional circuitry 120. FIG. 1A shows an example where circuit portion 124 can include a processing core (e.g., a core of a CPU). However, circuit portion 124 can be other part of functional circuitry 120.

Circuit path 122 can include data path, a clock path, or other circuit paths in functional circuitry 120. In an example, circuit path 122 can include a critical path in functional circuitry 120. Circuit path 122 includes transistors configured to perform the function of circuit path 122.

Digital aging sensor 101 can include circuit elements that mimics the structure of circuit path 122. Digital aging sensor 101 can operate to perform measurement on the circuit elements of digital aging sensor 101 and provide information that indicate operation degradation of circuit path 122 due to aging (e.g., aging of transistors of circuit path 122). FIG. 1A shows digital aging sensor 101 being outside other components of apparatus 100 as an example. However, digital aging sensor 101 can be embedded in functional circuitry 120. In an example, digital aging sensor 101 can be located in (e.g., formed in) circuit portion 124 or near circuit portion 124. The information provided by digital aging sensor 101 can be used (e.g., used by power control circuitry 130) or by other components of apparatus 100 for improvement in operations in part of apparatus (e.g., compensation for degradation of circuit path 122) or for other functions (e.g., reliability management) in apparatus 100.

As shown in FIG. 1A, digital aging sensor 101 can include control circuitry 110, a delay line 111, a delay line 112, a time-to-digital converter (TDC) TDC 113, and logic circuitry 114, which include a circuit 115.

Control circuitry 110 can include a signal generator 102, a frequency counter 104, at least one finite state machine (FSM), such as FSM 106 and FSM 108. Control circuitry 110 can include hardware, firmware, software, or any combination of hardware, firmware, and software to perform activities (e.g., operations) described herein (e.g., operations associated with digital aging sensor 101).

Digital aging sensor 101 can operate to track (e.g., monitor) the delay degradation of delay paths (e.g., circuit path 122). Aging degradation of part of digital aging sensor 101 (e.g., delay line 112) can follow the operating voltage, frequency, and temperature of the components (e.g., functional circuitry 120) of apparatus 100 in which digital aging sensor 101 resides (is embedded). For example, digital aging sensor 101 can be located in near or embedded in functional circuitry 120, such that part of digital aging sensor 101 (e.g., delay line 112) can go through a similar or the same aging as circuit path 122 of functional circuitry 120 during regular operation of circuit path 122. Digital aging sensor 101 can also perform a calibration operation to set delay values associated with digital aging sensor 101 for each device (e.g., each die) that includes digital aging sensor 101.

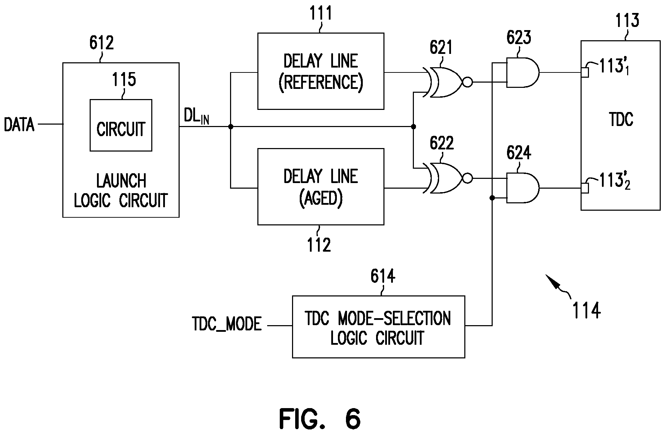

In FIG. 1A, logic circuitry 114 of digital aging sensor 101 can operate to receive signals (e.g., activity pattern) from signal generator 102. Logic circuitry 114 operate to enable circuit 115 to provide signals to delay line 111 and delay line 112. Logic circuitry 114 can include logic circuit elements to enable a precise starting point for signals provided to delay line 111 and delay line 112. FIG. 6 (described below) shows an example of logic circuitry 114.

Delay line 111 of digital aging sensor 101 in FIG. 1A, can be called a reference delay line (or unaged (or fresh) delay line). Delay line 111 can be located in a switched voltage area. Power can be provided to delay line 111 during a measurement mode. Power can be disconnected from delay line 111 during a time interval of the non-measurement mode (e.g., an aging mode). This way allows delay line 111 to remain freshness (e.g., remain unaged) to provide accurate aging sensing operation.

Delay line 112 can be called an aged delay line. Delay line 112 can be located in a continuous (e.g., always on) voltage area. Power can be provided (e.g., continuously provided) to delay line 112 during both a time interval of the measurement mode and a time interval of the aging mode. This way allows delay line 112 to be in similar condition (e.g., similar signal toggling rate, and similar operating voltage and temperature) as the circuit path (e.g., circuit path 122) that delay line 112 is designed to monitor.

As shown in FIG. 1A, delay line 111 can include a node (e.g., input node) 111' and a node (e.g., output node) 111". Delay line 112 can include a node (e.g., input node) 112' and a node (e.g., output node) 112".

Circuit 115 can include an output node 115" coupled to both nodes (e.g., input nodes) 111' and I12' of respective delay line 111 and delay line 112. Circuit 115 can provide a signal $DL_{IN}$ (from node 115") to node 111' of delay line 111 as a signal (e.g., input signal) $DL1_{IN}$. Digital aging sensor 101 can propagate signal $DL1_{IN}$ through delay line 111, which provides (e.g., outputs) a signal (e.g., output signal) $DL1_{OUT}$.

Circuit 115 can provide the same signal $DL_{IN}$ (from node 115") to node 112' of delay line 112 as a signal (e.g., input signal) $DL2_{IN}$. Digital aging sensor 101 can propagate signal $DL2_{IN}$ through delay line 112, which provides (e.g., outputs) a signal (e.g., output signal) $DL2_{OUT}$.

TDC 113 can include nodes (e.g., input nodes) $113_1'$ and $113_2'$ to receive signals $DL1_{OUT}$ and $DL2_{OUT}$, respectively. TDC 113 can operate as a stopwatch and measures a time difference between a time delay (e.g., time-of-flight) of signal $DL1_{IN}$ propagating through delay line 111 and a time delay (e.g., time-of-flight) signal $DL2_{IN}$ propagating through delay line 112. Based on the time difference, TDC 113 can provide (e.g., generate) information CODE and store it in registers (e.g., flip-flops) in TDC 113. Information CODE can be provided to output (e.g., output nodes) 113" of TDC 113 for further processing (e.g., processed by power control circuitry 130).

Digital aging sensor 101 can include (e.g., can be configured to operate in) two different modes: an aging mode (e.g., a non-measurement mode) and a measurement mode. Control circuitry 110 can control which mode (aging mode or measurement mode) digital aging sensor 101 operates. The measurement mode can be activated (e.g., triggered) in selected intervals (to generate information CODE). In an example, the selected intervals can be programmable intervals. Alternatively, or additionally, the measurement mode can be activated manually.

In the aging mode, the aging sensitive circuits (e.g., delay line 112) are being aged, using an activity pattern (e.g., a signal having a sequence of rising and falling edges) that can be provided by (e.g., configured in) the signal generator 102. In the aging mode, logic circuitry 114 receives the activity pattern and provide it to delay line 112. The activity pattern enters delay line 112, which toggles (and thus ages) with a rate determined by the activity pattern and a system clock frequency (e.g., clock signal CK in FIG. 1A). Clock signal CK can also be the same as the clock signal (e.g., system clock) used by functional circuitry 120. During the aging mode, delay line 111 and TDC 113 are switched off (e.g., deactivated and power is disconnected from delay line 111 and TDC 113). Deactivating (disconnecting power from) delay line 111 and TDC 113 during the aging mode allows delay line 111 and TDC 113 to maintain their freshness (e.g., to not age) for purposes of performing an aging sensing described herein.

In the measurement mode, delay line 111 and TDC 113 can be switched on (e.g., activated and power is connected to delay line 111 and TDC 113) to be part of an aging sensing operation of digital aging sensor 101. In the measurement mode, activity pattern generation (e.g., for aging mode) provided to logic circuitry 114 can be paused. However, signal generator 102 can operate to generate a rising edge (rising edge signal) or a falling edge (falling edge signal) to be used in the measurement mode. In the measuring mode, logic circuitry 114 can operate to concurrently (e.g., simultaneously) provide the rising edge (or the falling edge) to input nodes 111' and 112' of delay line 111 and delay line 112, respectively.

As shown in FIG. 1A, apparatus 100 can include a node (e.g., supply rail node) 191 to receive a voltage (e.g., supply voltage Vcc). Delay line 112 can include a node (e.g., supply node of delay line 112) 112S.

Delay line 112 can operate in the continuous power domain, such that power (e.g., Vcc) from node 191 can be continuously provided to node 112S of delay line 112. Digital aging sensor 101 can include a switch SW2 coupled between node 191 and node 112S of delay line delay line 112. Control circuitry 110 can operate to control (e.g., turn on or turn off) switch SW2 (e.g., using a signal CTL2) based on the modes digital aging sensor 101. For example, control circuitry 110 can turn on switch SW2 during both measurement mode and aging mode to continuously connect node 112S to node 191. Thus, power (e.g., Vcc) can be provided to delay line 112 during both measurement mode and aging mode of digital aging sensor 101. This way, delay line 112 can age at a similar aging rate as components (e.g., circuitry path 121) of functional circuitry 120 because power (e.g., Vcc) from node 191 can also be continuously provided to functional circuitry functional circuitry 120. The similar aging rate allow digital aging sensor 101 to use delay line 112 to track delay degradation of components (e.g., circuitry path 121) of functional circuitry functional circuitry 120.

Delay line 111 and TDC 113 can operate in the switched power domain. As shown in FIG. 1A, delay line 111 can include a node (e.g., supply node of delay line 111) 111S. TDC 113 can include a node (e.g., supply node) 113S. Digital aging sensor 101 can include a switch SW1 coupled between node 191 and each of node 111S (of delay line 111) and node 113S (of TDC 113). Control circuitry 110 can operate to control (e.g., turn on or turn off) switch SW1 based on the modes digital aging sensor 101. For example, control circuitry 110 can turn on switch SW1 during the measurement mode to provide power (e.g., Vcc) to delay line 111 and TDC 113 and activate delay line 111 and TDC 113. In another example, control circuitry 110 can turn off switch SW1 during the aging mode (e.g., non-measurement mode) to disconnect power (e.g., Vcc) from delay line 111 and TDC 113 and deactivate delay line 111 and TDC 113. Power from node 191 can be provided to delay line 112 while power from node 191 is disconnected from delay line 111 and TDC 113.

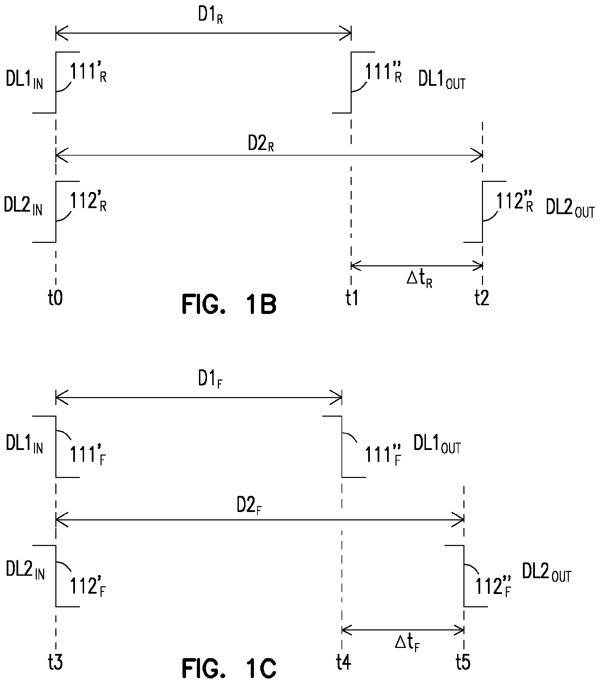

FIG. 1B shows an example of time delay of rising edges of the signals of digital aging sensor 101 of FIG. 1A, according to some embodiments described herein. In FIG. 1B, time t0 occurs before time t1, and time t1 occurs before time t2. As shown in FIG. 1B, signal $DL1_{IN}$ can include a rising edge $111'_R$. Signal $DL1_{OUT}$ can include a rising edge $111''_R$. Signal $DL2_{IN}$ can include a rising edge $112'_R$. Signal $DL2_{OUT}$ can include a rising edge $112''_R$.

Time delay (e.g., time-of-flight) $D1_R$ is an amount of time for signal $DL1_{IN}$ to propagate through delay line 111 of FIG. 1A (to become signal $DL1_{OUT}$). Time delay (e.g., time-of-flight) $D2_R$ is an amount of time for signal $DL2_{IN}$ to propagate through delay line 112 of FIG. 1A (to become signal $DL2_{OUT}$).

A time difference $\Delta t_R$ is the difference between time delay $D2_R$ and time delay $D1_R$ (e.g., $\Delta t_R = D2_R - D1_R = t2 - t1$). During measurement mode, digital aging sensor 101 can use the value of time difference $\Delta t_R$ to provide (e.g., generate) information CODE (at output 113" of TDC 113 in FIG. 1A).

FIG. 1C shows an example of time delay of falling edges of the signals of digital aging sensor 101 of FIG. 1A, according to some embodiments described herein. In FIG. 1C, time t3 occurs before time t4, and time t4 occurs before time t5. As shown in FIG. 1C, signal $DL1_{IN}$ can include a falling edge $111'_F$. Signal $DL1_{OUT}$ can include a falling edge $111''_F$. Signal $DL2_{IN}$ can include a falling edge $112'_F$. Signal $DL2_{OUT}$ can include a falling edge $112''_F$.

Time delay (e.g., time-of-flight) $D1_F$ is an amount of time for signal $DL1_{IN}$ to propagate through delay line 111 of FIG. 1A (to become signal $DL1_{OUT}$). Time delay (e.g., time-of-flight) $D2_F$ is an amount of time for signal $DL2_{IN}$ to propagate through delay line 112 of FIG. 1A (to become signal $DL2_{OUT}$).

A time difference $\Delta t_F$ is the difference between time delay $D2_F$ and time delay $D1_F$ (e.g., $\Delta t_F = D2_F - D1_F = t5 - t4$). During measurement mode, digital aging sensor 101 can use the value of time difference $\Delta t_F$ to provide (e.g., generate) information CODE (at output 113" of TDC 113 in FIG. 1A).

The following description describes detail of an example measurement mode of digital aging sensor 101.

In this example measurement mode, digital aging sensor 101 can measure a total delay degradation $\Delta t$ (delta t), which is based on equation (1) below.

$$\Delta t = \left[ \left( 1 - \frac{R_2}{R_1} \right) + \left( \frac{\Delta tdc * TDCstepval}{2} \right) \right] * T_1 \quad (1)$$

In equation (1), the term TDCstepval is a known value that represents the per-aging-step delay degradation percentage. This value can be determined by aging simulations and later be refined by data from aging experiments (e.g., experiments on a test device (e.g., test silicon die).

In equation (1), period T1 is a known value that is the period (cycle time) of a clock signal (e.g., clock signal CK in FIG. 1A) used in the component (e.g., functional circuitry 120) in which digital aging sensor 101 resides. In an example, period T1 can be a period of a core clock signal used in functional circuitry 120.

The following description describes ways to obtain other values ($R_1$, $R_2$, and Dtdc) for equation (1).

In equation (1), $R_1$ (frequency $R_1$) and $R_2$ (frequency $R_2$) is the frequency associated with the signal time-of-flight through delay line 111 and the signal time-of-flight through delay line 112, respectively, in a ring-oscillator configuration (e.g., closed loop configuration). As part of the measurement, the ring-oscillator configuration can be turned on. In the ring-oscillator configuration, node (e.g., output node) 111" (FIG. 1A) of delay line 111 can be connected to node (e.g., input node) 111' of delay line 111. Node (e.g., output node) 112" of delay line 112 can be connected to node (e.g., input node) 112' of delay line 112. Then, a signal (from circuit 115 of FIG. 1) can be provided to delay line 111 and delay line 112. A frequency counter (e.g., frequency counter 103 (FIG. 1A) can be used to calculate the values of frequency $R_1$ and frequency $R_2$ of equation (1). The term $1 - (R_1 / R_2)$ in equation (1) is the value for aging induced frequency shift of frequency $R_2$ with respect to frequency $R_1$.

The frequency measurement described above gives an average of rising and falling edge delay degradation. In reality, rising and falling edge delay degradation can differ. It can depend on which aging mechanism dominates aging, such as whether n-type transistor aging (e.g., n-type metal-oxide semiconductor (NMOS) or p-type metal-oxide semiconductor (PMOS) transistor aging (e.g., PMOS) dominates. Thus, to improve measurement accuracy, distinguishing between rising edge aging and falling edge aging (e.g., for worst case) can also be measured, as described below.

The following description describes calculation for the term $\Delta tdc$ of equation (1) above. The term $\Delta tdc$ is the difference in code values between a code (TDC code) corresponding to rising edge delay (e.g., like $\Delta t_R$ in FIG. 1B) and a code (TDC code) corresponding to falling edge delay (e.g., like $\Delta t_F$ in FIG. 1C). The TDC mode measurement can distinguish between rising edge aging and falling edge aging.

To measure $\Delta tdc$, the ring-oscillator configuration (described above) is turned off. This places delay line 111 and delay line 112 in an open loop configuration. In this open loop configuration, the input and output nodes of delay line 111 are disconnected from each other (to not to form a ring oscillator). The open loop allows delay line 111 to be used as a delay line. Similarly for delay line 112, in the open loop configuration, the input and output nodes of delay line 112 are disconnected from each other, allowing delay line 112 to be used a delay line.

After delay line 111 and delay line 112 are in the open loop configuration, digital aging sensor 101 can begin the measurement of the rising edge delay difference. In this measurement, a rising edge signal (e.g., like the rising edge signal in FIG. 1B) can be provided to both delay line 111 and delay line 112. TDC 113 can measure the rising edge delay difference (e.g., like $\Delta t_R$ in FIG. 1B) and provide a code (e.g., $CODE_R$) corresponding the rising edge delay difference.

After the measurement of the rising edge delay difference is finished (e.g., after $CODE_R$ is obtained), digital aging sensor 101 can begin the measurement of the falling edge delay difference. In this measurement, a falling edge signal (e.g., like the falling edge signal in FIG. 1C) can be provided to both delay line 111 and delay line 112. TDC 113 can measure the falling edge delay difference (e.g., like $\Delta t_F$ in FIG. 1C) and provide a code (e.g., $CODE_F$) corresponding to the falling edge delay difference.

The value of Dtdc can be calculated as follows.

Dtdc = $CODE_R$ - $CODE_F$, where $CODE_R$ is code value (measured by TDC 113) corresponds to the difference between the rising edge delay difference, and $CODE_F$ value (measured by TDC 113) corresponds to the falling edge delay difference.

After the value of Dtdc is calculated, the value of total delay degradation $\Delta t$ can be calculated based on equation (1) above.

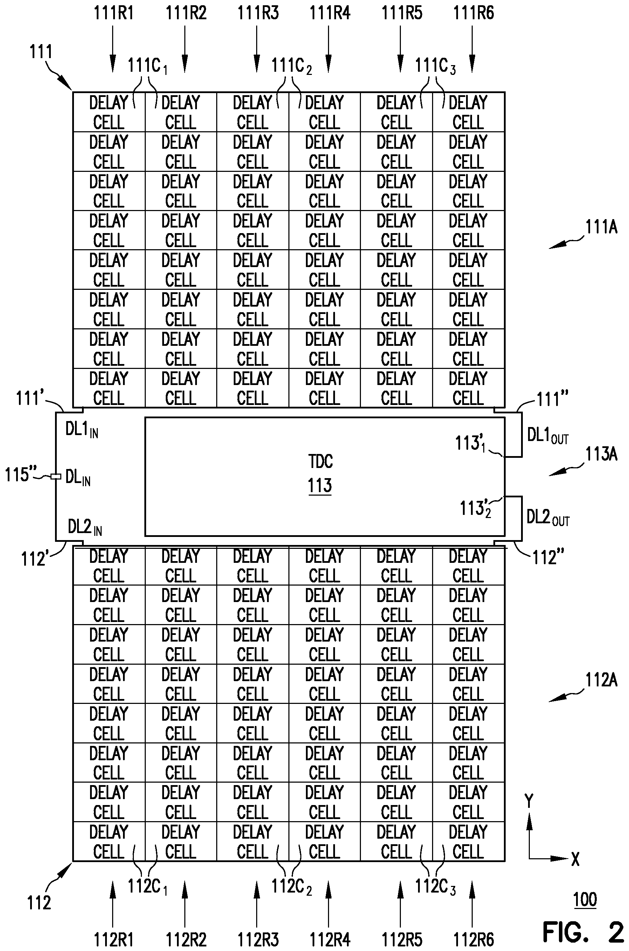

FIG. 2 shows a top view (e.g., layout) of a structure of digital aging sensor 101 including the structures of delay line 111, delay line 112, and TDC 113 of FIG. 1A, according to some embodiments described herein. As shown in FIG. 2, digital aging sensor 101 can includes an area (e.g., circuit portion) 111A, an area 112A, and 113A adjacent and between area 111A and area 112A. Areas 111A, 112A, and 113A are locations (physical locations) of delay line 111, delay line 112, and TDC 113, respectively. FIG. 2 also shows the locations of nodes 111' and node 111" of delay line 111, and the locations of nodes 112' and node 112" of delay line 112.

As shown in FIG. 2, delay line 111 can include rows (multiple rows) 111R1 through 111R6 having respective delay cells $111C_1$, delay cells $111C_2$, and delay cells $111C_3$. Rows 111R1 through 11R6 can be formed (e.g., arranged) adjacent (located next to) each other in the X-direction. The X-direction is perpendicular to a Y-direction. The X-Y directions correspond to the directions of the plane view (e.g., layout view) of digital aging sensor 101.

As shown in FIG. 2, each of rows 111R1 through 111R6 can include delay cells adjacent (located next to) each other in the Y-direction. For example, row 111R1 and 111R2 can include delay cell $111C_1$ adjacent to each other in the Y-direction. Row 111R3 and 111R4 can include delay cells $111C_2$ adjacent each other in the Y-direction. Row 111R5 and 111R6 can include delay cells $111C_3$ adjacent each other in the Y-direction.

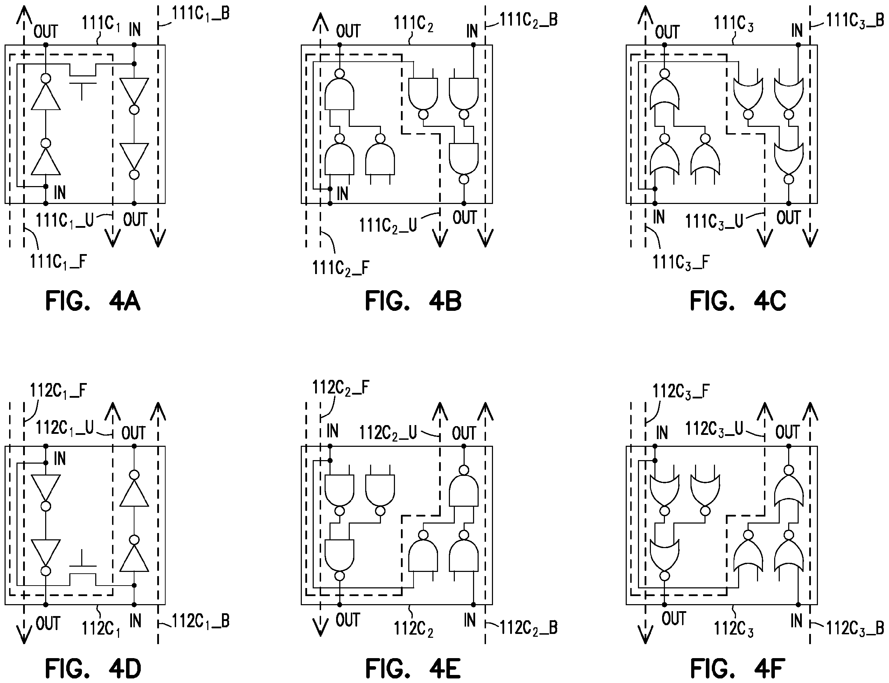

Each of delay cells $111C_1$, delay cells $111C_2$, and delay cells 111C3 can include circuit elements (e.g., logic gates), as described below with reference to FIG. 4A through FIG 4F.

Delay line 112 can include circuit elements that are arranged in ways similar to (or the same as) those of delay line 111. As shown in FIG. 2, delay line 112 can include rows (multiple rows) 112R1 through 112R6 of respective delay cells $112C_1$, delay cells $112C_2$, and delay cells $112C_3$. Rows 112R1 through 11R6 can be formed (e.g., arranged) adjacent (located next to) each other in the X-direction.

As shown in FIG. 2, each of rows 112R1 through 112R6 can include delay cells adjacent (located next to) each other in the Y-direction. For example, row 112R1 can include delay cells 112C, adjacent each other in the Y-direction. Row 112R2 can include delay cells $112C_2$ adjacent each other in the Y-direction. Row 112R1 can include delay cells $112C_3$ adjacent each other in the Y-direction. Each of delay cells 112C can include circuit elements (e.g., logic gates), as described below with reference to FIG. 4D, FIG. 4E, and FIG. 4F.

The number of delay cells can be equal among rows 112R1 through 112R6. For example, each of rows 112R1 through 112R6 can have a number of C (C is an integer) delay cells. In the example of FIG. 2, each of rows 111R1 through 112R6 can include 8 delay cells (e.g., C = 8). Each of rows 112R1 through 112R6 can include 8 delay cells (e.g., C = 8). The number of rows of delay cells of delay line 111 can be equal to the number of rows of delay cells of delay line 112.

FIG. 2 shows six rows (rows 111R1 through 111R6) of delay cells in delay line 111 and six rows (rows 112R1 through 112R6) of delay line 112, as an example. However, the rows of delay cells in delay line 111 can be different from six. The rows of delay cells in delay line 112 can be different from six. FIG. 2 shows an equal number (e.g., eight) of delay cells among rows 111R1 through 111R6 as an example. However, two or more of rows 111R1 through 111R6 can have different (unequal) numbers of delay cells among each other. FIG. 2 shows an equal number (e.g., eight) of delay cells among rows 112R1 through 112R6 as an example. However, two or more of rows 112R1 through 112R6 can have different (unequal) numbers of delay cells among each other.

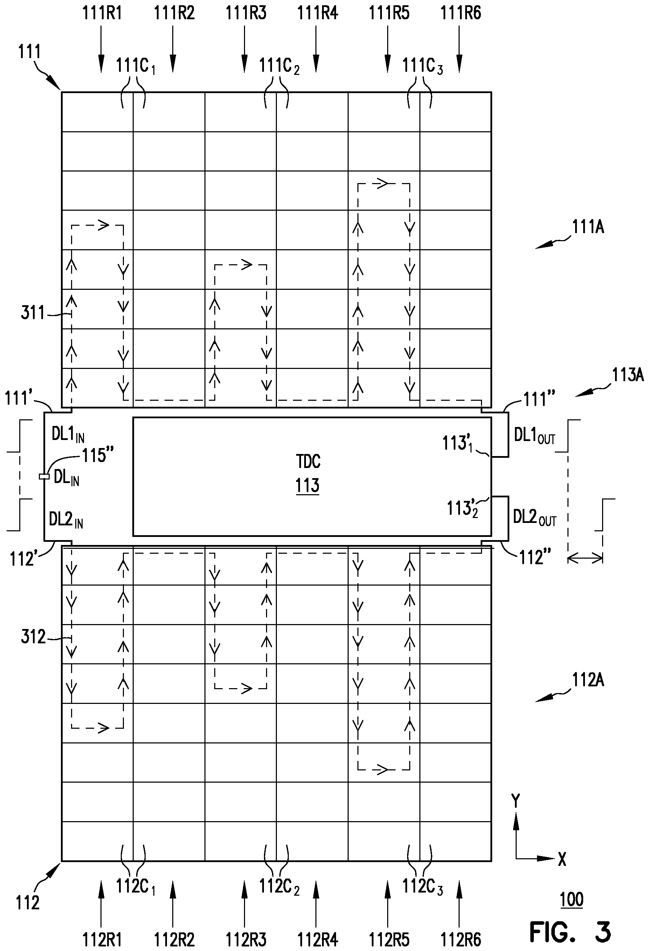

FIG. 3 shows an example propagation path (signal path) 311 that goes through delay line 111, according to some embodiments described herein. Propagation path 311 can begin from node 111' to node 111". In the example of FIG. 3, propagation path 311 goes through 5 delay cells $111C_1$ (e.g., active delay cells) of row 111R1; 4 delay cells (e.g., active delay cells) $111C_2$ of row 111R3; and 6 delay cells (e.g., active delay cells) $111C_3$ of row 111R5. Thus, in the example of FIG. 3, propagation path 311 go through 15 delay cells among the total number of delay cells (e.g., 48 delay cells) of delay line 111.

FIG. 3 also shows an example propagation path (signal path) 312 that goes through a portion of delay line 112. Propagation path 312 can begin from node 112' to node 112". In the example of FIG. 3, propagation path 312 goes through 5 delay cells $112C_1$ (e.g., active delay cells) of row 112R1; 4 delay cells (e.g., active delay cells) $112C_2$ of row 112R3; and 6 delay cells (e.g., active delay cells) $112C_3$ of row 112R5. Thus, in the example of FIG. 3, like propagation path 311, propagation path 312 also go through 15 delay cells among the total number of delay cells (48 delay cells) of delay line 112.

The number of active delay cells (e.g., configured delay cells) in propagation path 311 and propagation path 312 are configured based on a delay of a selected circuit path (e.g., circuit path 122). This allows propagation path 311 and propagation path 312 to mimic the selected circuit path for the aging sensing operation.

During measurement mode, digital aging sensor 101 can propagate signal $DL1_{IN}$ from node 111' and signal $DL2_{IN}$ from node 112' through propagation path 311 and propagation path 312, respectively. Signal $DL1_{OUT}$ and $DL2_{OUT}$ outputted from propagation path 311 and propagation path 312, respectively, can be provided to (e.g., inputted into) TDC 113, which uses signal $DL1_{OUT}$ and $DL2_{OUT}$ as part of generating information CODE.

FIG. 3 shows each of propagation paths 311 and 312 includes 15 delay cells as an example. However, the number of delay cells and propagation path in each of delay line 111 and delay line 112 can be different from propagation paths 311 and 312, depending on the delay path in the components of apparatus 100 that digital aging sensor 101 is designed to track.

FIG. 4A, FIG. 4B, and FIG. 4C show schematic diagrams of delay cells $111C_1$, $111C_2$, and $111C_3$ of delay line 111 of FIG. 3, according to some embodiments described herein. For simplicity, the circuit elements (e.g., inverter, logic gates (e.g., NAND and NOR gates) of the delay cells shown in FIG. 4A through FIG. 4F are not labeled. As shown in FIG. 4A, delay cell $111C_1$ can include inverters and a switch (e.g., a transistor or a multiplexer). The circuit elements of delay cell $111C_1$ can be coupled to each other as shown in FIG. 4A to form paths $111C_1\_F$, path $111C,\_B$, and path $111C_1\_U$ (which can be called "forward path", "backward path", and "U-turn path", respectively).

In the delay cells (delay cells $111C_1$, $111C_2$, $111C_3$, $112C_4$, $112C_2$, and $112C_3$) described herein with respect to FIG. 4A through FIG. 4F, each of these delay cells can include a "forward path", a "backward path", and a "U-turn path". Each of these paths is a circuit path that can be configured to propagate a signal (e.g., signal $DL1_{IN}$). In each delay cell, the paths can be selectively configured (e.g., programmed) to be active or inactive depending on a circuit path (e.g., circuit path 122 of FIG. 2) the digital aging sensor 101 is designed to track. In a delay cell, an active path is part of a propagation path (e.g., propagation path 311) of a signal. An inactive path is not part of a propagation path (e.g., propagation path 311) of a signal. Thus, a propagation path (e.g., propagation path 311) does not propagate through an inactive path.

Each of the delay cells described herein with respect to FIG. 4A through FIG. 4F can include two input nodes (at which a signal enters the delay cell) and two output nodes (at which a signal can exit the delay cell (e.g., to move to the next delay cell). The input node and output node of a delay cell is labeled "IN" and "OUT", respectively.

As shown in FIG. 4A, in delay cell $111C_1$, each of paths $111C_1\_F$, $111C,\_B$, and $111C_1\_U$ can be coupled between an input node (IN) and an output node (OUT).

As shown in FIG. 4B, delay cell $111C_2$ can include logic gates (e.g., NAND gates) that can be coupled to each other as shown in FIG. 4B to form paths $111C_2\_F$, path $111C_2\_B$, and path $111C_2\_U$ (which can be called "forward path", "backward path", and "U-turn path", respectively). As shown in FIG. 4B, each of paths $111C_2\_F$, path $111C_2\_B$, and path $111C_2\_U$ can be coupled between an input node (IN) and an output node (OUT).

As shown in FIG. 4C, delay cell $111C_2$ can include logic gates (e.g., NOR gate) can be coupled to each other as shown in FIG. 4C to form paths $111C_3\_F$, path $111C_3\_B$, and path $111C_3\_U$ (which can be called "forward path", "backward path", and "U-turn path", respectively). As shown in FIG. 4C, each of paths $111C_3\_F$, path $111C_3\_B$, and path $111C_3\_U$ can

be coupled between an input node (IN) and an output node (OUT).

FIG. 4D, FIG. 4E, and FIG. 4F shows schematic diagrams of delay cells 112C,, 112C$_2$, and 112C$_3$ of delay line 112 of FIG. 3, according to some embodiments described herein. Delay cells 112C$_1$, 112C$_2$, and 112C$_3$ of delay line 111 can have the same circuit elements and structures as delay cells 111C$_1$, 111C$_2$, and 111C$_3$, respectively, of delay line 111. Thus, the following description of FIG. 4D, FIG. 4E, and FIG. 4F is similar to those of FIG. 4A, FIG. 4B, and FIG. 4C.

As shown in FIG. 4D, delay cell 112C, can include inverters and a switch coupled to input (IN) and output nodes (OUT) similar to delay cell 111C$_1$ of FIG. 4A. As shown in FIG. 4D, delay cell can include paths 112C,_F, path 112C,_B, and path 112C,_U.

As shown in FIG. 4E, delay cell 112C$_2$ can include logic gates (e.g., NAND gates) coupled to input (IN) and output nodes (OUT) similar to delay cell 111C$_2$ of FIG. 4B. As shown in FIG. 4E, delay cell can include paths 112C$_2$_F, path 112C$_2$_B, and path 112C$_2$_U.

As shown in FIG. 4F, delay cell 112C$_3$ can include logic gates (e.g., NOR gates) coupled to input (IN) and output nodes (OUT) similar to delay cell 112C$_2$ of FIG. 4C. As shown in FIG. 4E, delay cell 112C$_3$ can include paths 112C$_3$_F, path 112C$_3$_B, and path 112C$_3$_U.

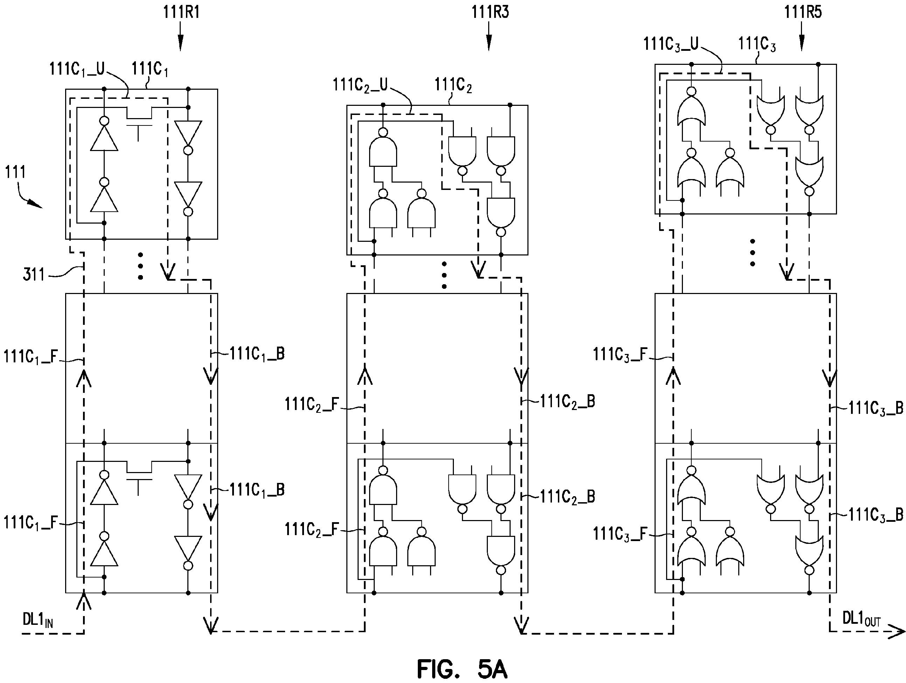

FIG. 5A shows more details of propagation path 311 of FIG. 3 at some of the delay cells of delay line 111, according to some embodiments described herein. As shown in FIG. 5A, propagation path 311 can propagate through paths 111C$_1$_F (e.g., forward paths) and paths 111C$_1$_B (e.g., backward paths) of four delay cells 111C$_1$ (only two are shown) of row 111R1, and through path 111C$_1$_U (e.g., U-turn path) of one delay cell 111C$_1$ in row 111R1.

From row 111R1, propagation path 311 can continue to propagate through paths 111C$_2$_F (e.g., forward paths) and paths 111C$_2$_B (e.g., backward paths) of three delay cells 111C$_2$ row 111R3, and through path 111C$_2$_U (e.g., U-turn path) of one delay cell 111C$_2$ in row 111R3.

From row 111R3, propagation path 311 can continue to propagate through paths 111C$_3$_F (e.g., forward paths) and paths 111C$_3$_B (e.g., backward paths) of five delay cells 111C$_3$ (only two are shown) of row 111R5, and through path 111C$_3$_U (e.g., U-turn path) of one delay cell111C$_3$ in row 111R5.

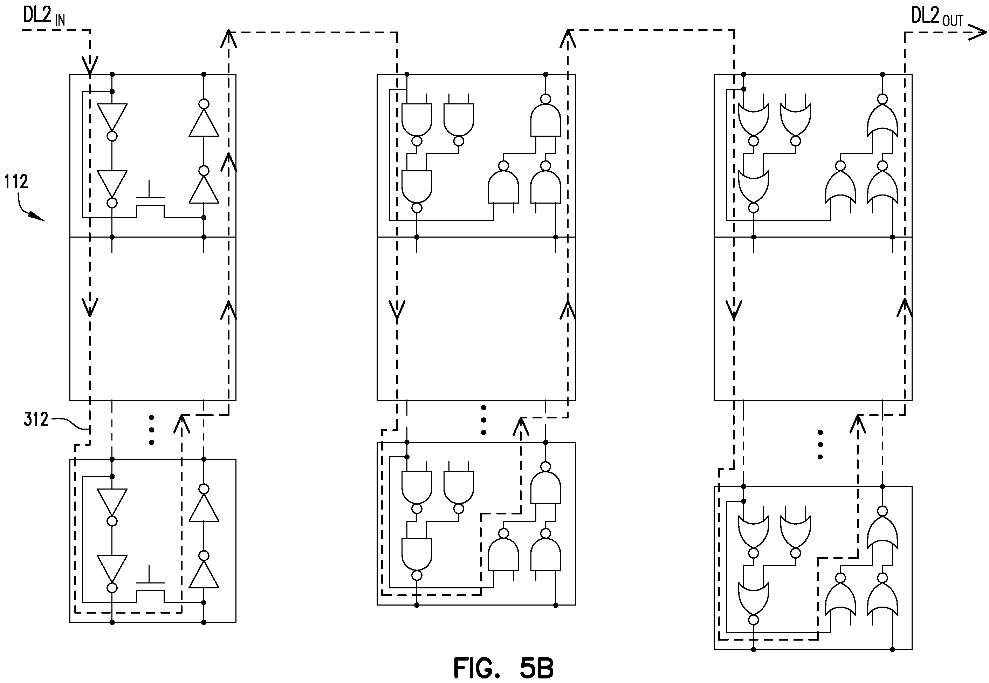

FIG. 5B shows more details of propagation path 312 of FIG. 3 at some of the delay cells of delay line 112, according to some embodiments described herein. As shown in FIG. 5A, propagation path 312 can propagate through paths 112C$_1$_F (e.g., forward paths) and paths 112C$_1$_B (e.g., backward paths) of four delay cells 112C$_1$ (only two are shown) of row 112R1, and through path 112C,_U (e.g., U-turn path) of one delay cell 112C, in row 112R1.

From row 112R1, propagation path 312 can continue to propagate through paths 112C$_2$_F (e.g., forward paths) and paths 112C$_2$_B (e.g., backward paths) of three delay cells 112C$_2$ (only two are shown) of row 112R3, and through path 112C$_2$_U (e.g., U-turn path) of one delay cell 112C$_2$ in row 112R3.

From row 112R3, propagation path 312 can continue to propagate through paths 112C$_2$_F (e.g., forward paths) and paths 112C$_2$_B (e.g., backward paths) of five delay cells 112C$_2$ (only two are shown) of row 112R5, and through path 112C$_3$_U (e.g., U-turn path) of one delay cell 112C$_3$ in row 112R5.

The description with respect to FIG. 4A through FIG. 4F show example specific delay elements (e.g., inverter, NAND gates, and NOR gates) in the delay cells of delay line 111 and delay line 112. However, delay cells with different circuit elements and operating parameters can be used. For example, a delay cell with any combination of circuit elements (e.g., logic gates) and different drive strengths can be used. Further, delay cells for different types of circuit paths (e.g., data paths and clock paths) can also be used.

As described above with reference to FIG. 2 through FIG. 5B, each of delay line 111 and delay line 112 can be a configurable delay line (e.g., tunable delay line) where the delay path (e.g., propagation paths 311 and 312) in delay line 111 and delay line 112 can be configured (e.g., selected) by selecting an appropriate number of delay cells (e.g., as shown in FIG. 3). The structure of delay line 111 and delay line 112 (as shown in FIG. 2 and FIG. 3) allow digital aging sensor 101 to have a relatively small footprint. Such a footprint allows digital aging sensor 101 to be embedded in components (e.g., functional circuitry 120) of apparatus 100 at selected location (e.g., at a critical spot) to provide accurate aging sensing.

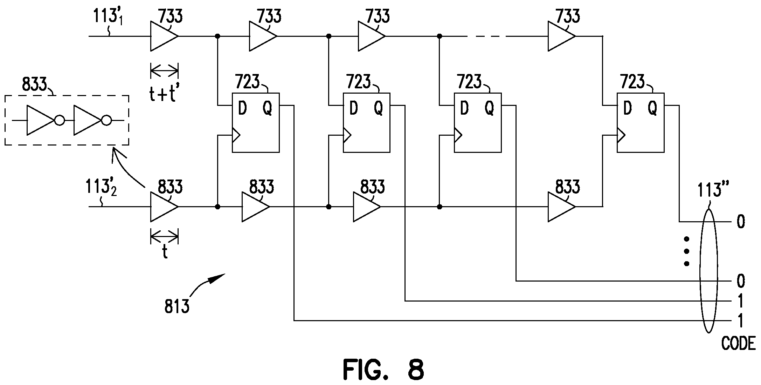

In an alternative structure of digital aging sensor 101, each of delay line 111 and delay line 112 can be a non-tunable (e.g., fixed or static) delay line instead of a tunable delay line. For example, in an alternative structure of digital aging sensor 101, a delay path (e.g., propagation path 311 and 312) in delay line 111 and delay line 112 can be formed from delay cells which are chosen based on experience and cell statistics from known sources (e.g., a related device). In an example, TDC 113 of digital aging sensor 101 having non-tunable delay lines can include TDC 813 described below with reference to FIG. 8. Including TDC 813 in digital aging sensor 101 allow digital aging sensor 101 to accommodate a relatively wide voltage range and aging steps and maintain a relatively small footprint (e.g., a footprint similar to that of digital aging sensor 101 having tunable delay lines).

FIG. 6 shows a schematic diagram logic circuitry 114 of digital aging sensor 101 FIG. 1A, according to some embodiments described herein. In FIG. 6 circuit (e.g., flip-flop) 115 can correspond circuit 115 of FIG. 1A. Information DATA can include signals (e.g., having activity pattern) used to age delay line 112 during the age mode. In the measuring mode, information DATA can include a signal (e.g., rising edge or falling edge) that is used by digital aging sensor 101 to measures the total delay degradation Δt.

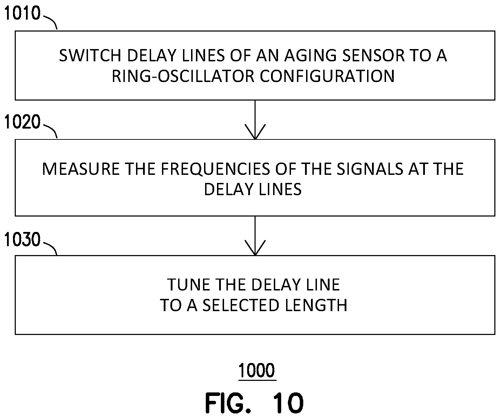

As shown in FIG. 6, logic circuitry 114 can include logic circuits 612 and 614, and logic gates 621, 622, 623, and 624, coupled to delay lines 111 and 112 and TDC 113. Logic circuit 612 can be called launch logic circuit, which receives the activity pattern coming from signal generator 102 and ensures a precise starting point for the signals going into delay line 111 and delay line 112. Logic circuit 614 can be called the TDC mode-selection logic circuit, which allows digital aging sensor 101 to switch between the measurement mode (described above) and an additional mode, which can be called a direct delay measurement mode. The direct delay measurement mode can be performed during a calibration operation (delay line calibration) to adjust (e.g., to trim) the length of the delay line. As described below (with reference to FIG. 10), the delay line calibration can be performed to adjust (e.g., trim) the length of delay line 111 and delay line 112 to a selected length. Such a selected length allows digital aging sensor 101 to provide enough number of aging steps over lifetime (e.g., a number of years) of TDC 113. In the delay line calibration operation (FIG. 10), delay line 111 and delay line 112 can be switched to a ring-oscillator (RO) configuration.

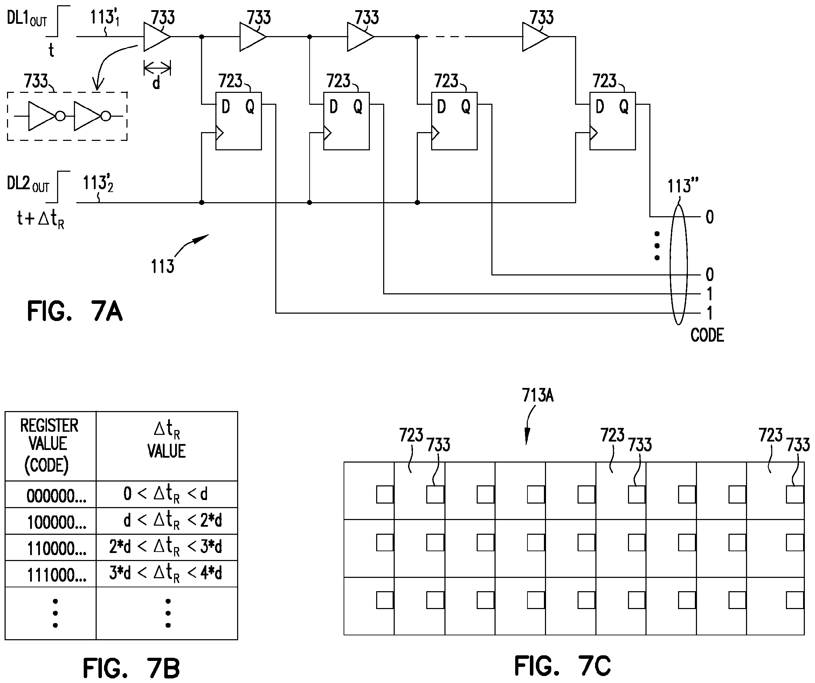

FIG. 7A shows a schematic diagram of TDC 113 of FIG. 1A, according to some embodiments described herein. As shown in FIG. 7A, TDC 113 can include flip-flops 723 and delay elements 733. As shown in FIG. 7A, an example of delay element 733 includes two-series connected inverters. Flip-flops 723 can include edged-trigger flip flops (e.., D-type edged-trigger flip flops).

The time resolution of TDC 113 is given by the signal throughput time through a single delay element 733. As shown in FIG. 7A, the signal throughput time of each delay element 733 can correspond to time delay d (e.g., d can be 5 picoseconds). Thus, in the example of FIG. 7A, the time resolution (e.g., step) of TDC 113 is d (e.g., 5ps).

As shown in FIG. 7A, input nodes $113'_1$ and $113'_2$ of TDC 113 can receive respective rising edges of signal $DL1_{OUT}$ and $DL2_{OUT}$, respectively. FIG. 7A shows an example of rising edges provided to nodes 113', and $113'_2$. However, respective falling edges of signal $DL1_{OUT}$ and $DL2_{OUT}$ can be provided to nodes 113', and $113'_2$.

As shown in FIG. 7A, TDC 113 can operate to provide information CODE at output 113" based on a time difference $\Delta t_R$ associated with rising edge delay. However, 7A, TDC 113 can operate to provide information CODE at output 113" based on a time difference $\Delta t_F$ associated with falling edge delay.

FIG. 7B is a chart showing example values for information CODE generated by TDC 113 of FIG. 7A based on the value of time difference $\Delta t_R$, according to some embodiments described herein. The values (digital value) of information CODE in FIG. 7B are based on the example of time delay d of each of delay element 733 (FIG. 7A). FIG. 7B shows example register values (stored in flip-flops 723 of FIG. 7A) based on the value of time difference $\Delta t_R$. As an example, if d = 5ps, then the register value is 110000 if the value of $\Delta t_R$ is less than 15ps and greater than ($10ps < \Delta t_R < 15ps$).

FIG. 7C shows a top view of (e.g., layout) of the structure of TDC 113 of FIG. 7A, according to some embodiments described herein. As shown in FIG. 7C, TDC 113 can occupy area 713A that can correspond to area 113A of FIG. 2. As shown in FIG. 7C, the locations (physical locations) of flip-flops 723 and delay elements 733 can be arranged in ways (e.g., in rows and columns in the X-Y directions) that a relatively small area can be used to form TDC 113.

In the techniques described above with reference to FIG. 7A, FIG. 7B, and FIG. 7C, measuring a time difference (e.g., time difference $\Delta t_R$ or $\Delta t_F$) between signals $DL1_{OUT}$ and $DL2_{OUT}$ (instead of measuring absolute times) provides a benefit that a relatively small TDC (e.g., the TDC 113, 813, or 913 described herein) can be used.

FIG. 8 shows a schematic diagram of TDC 813, which can be a variation of TDC 113 of FIG. 7A, according to some embodiments described herein. TDC 813 can substitute for TDC 113 of FIG. 1A. Differences between TDC 113 of FIG. 7A and TDC 813 of FIG. 8 include the addition of delay elements 833 of TDC 813 in FIG. 8. As shown in FIG. 8, an example of delay element 833 includes two-series connected inverters. TDC 813 can include a Vernier TDC.

As shown in FIG. 8, delay elements 833 can have signal throughput time corresponding to a time delay t. Delay elements 733 can have signal throughput time corresponding to a time delay t + t'. Thus, delay elements 833 can have a smaller signal throughput time than that of delay elements 733. As described above, the time resolution of TDC 113 in FIG. 7A is given time delay d of delay element 733 of FIG. 7A. In FIG. 8, the time resolution R of TDC 813 can be based on the difference between time delay t + t' of delay element 833 and time delay t of delay element 833. Thus, the time resolution of TDC 813 can be (t + t') - t = t'. Therefore, the time resolution of TDC 813 can be selected by selecting time delay (e.g., t) and a time delay t + t' of delay elements 833 and 733, respectively. As an example, time delay t' can be selected from different delay cell types, drive strengths, and threshold voltages to achieve a selected time resolution of TDC 813. For example, to achieve a time resolution of 1ps for TDC 813, time delays of delay element 733 and 833 can be selected to be 6 ps and 5 ps, respectively.

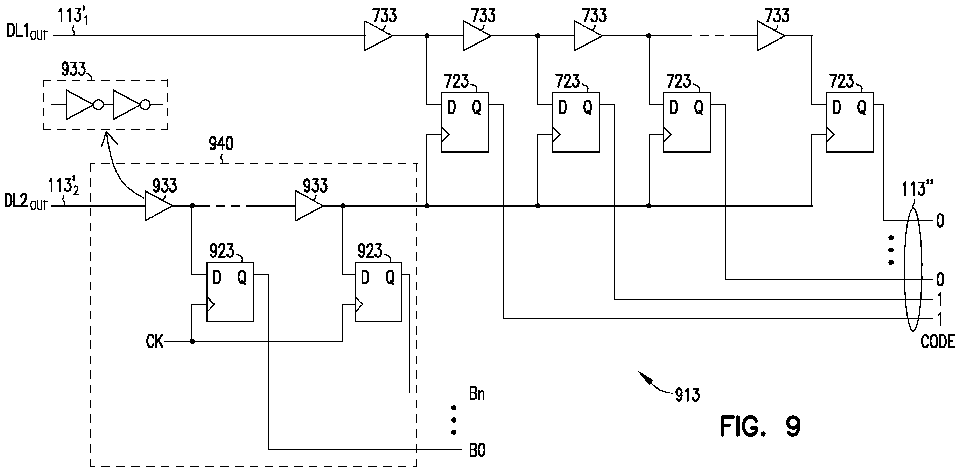

FIG. 9 shows a schematic diagram of TDC 913 which can be a variation of TDC 113 of FIG. 7A, according to some embodiments described herein. TDC 913 can substitute for TDC 113 of FIG. 1A. Differences between TDC 113 of FIG. 7A and TDC 913 of FIG. 9 include the addition of circuit 940. As shown in FIG. 9, TDC 913 can also include a number of series-connected delay elements 733 coupled to flip-flops 723. As shown in FIG. 9, circuit 940 can include flip-flops 923 and delay elements 933 that can be similar to flip-flops 723 and delay elements 733, respectively.

The structure of TDC 913 and circuit 940 allows TDC 913 to include a self-centering logic feature. In this feature allows shifting of the zero-aging position in TDC 913. In operation, the delay elements 933 can re-center the TDC zero-aging position in flip-flops 723 (the TDC registers) to reside after a certain number of bits. For example, if TDC 913 of FIG. 9 includes four of delay elements 933 (eight delay elements 933), TDC 913 can shift the zero position to the fourth flip-flop 723 (fourth register entry). In this example, measuring 5 aging steps in TDC 913 corresponds to (111111111000....) instead of (111110000000....) in TDC 713 of FIG. 7A). The self-centering logic feature enables measurement of a potential aging-induced speed-up of the delay through delay line 112. In the TDC register of TDC 913, a speed-up equivalent to one TDC resolution quantum would then manifest itself as (111000000000), for example. In FIG. 9, bits B0 through Bn can provide information associated with a calibration operation of TDC 913.

As described above, digital aging sensor 101 can be switched between the measurement mode and the direct delay measurement mode. The direct delay measurement mode can be used as an alternative calibration technique (e.g., without using a ring-oscillator (RO) configuration) to adjust (e.g. to trim) the delay line to the critical path length (e.g., length of circuit path 122) during a delay line calibration. In the alternative calibration technique, measurement of delay line 111 and delay line 112 can be based on the main clock signal (e.g., the clock signal used in functional circuitry 120). In the alternative calibration technique, delay elements can be successively added to the delay line, until the first flip-flop (e.g., flip-flop 923 next to node 113'$_2$ of TDC 913 in FIG. 9) in circuit 940 shows a value of "0" after sampling. This indicates that the signal time-of-flight through the delay line surpassed the time between 2 clock pulses. This means that the length of the delay line is now similar to (or the same as) the length of the critical path. In comparison with switching delay line 111 and delay line 112 to the ring-oscillator configuration during delay line calibration, the alternative calibration technique can have a lower total test time (e.g., test time in sort and class testing).

Digital aging sensor 101, as described above with reference to FIG. 1A through FIG. 9 has a relatively small footprint and operates to provide aging information for circuit paths that operate with a relatively wide range of operating voltage and temperature. This allows digital aging sensor 101 to be embedded at a selected spot (e.g., critical spot) to accurately measure age-induced signal degradation. To further improve the structures and measuring operations of digital aging sensor 101, different calibration techniques that can be performed on digital aging sensor 101 are described below.

FIG. 10 is a flowchart showing an example method 1000 of a calibration for a delay line of digital aging sensor 101, according to some embodiments described herein. The calibration in method 1000 can be called delay line calibration. Method 1000 can be performed to calibrate each of delay line 111 and delay line 112 (FIG. 1A), so that the delay line is configured to a selected length (e.g., an optimal TLD length) per voltage interval. During manufacturing, the part (e.g., silicon chip) that includes digital aging sensor 101 comes from different regions of a wafer, or from different lots. The part can be slow or fast with respect to the median. Method 1000 can perform the delay line calibration to calibrate the delay line of digital aging sensor 101 on per part (e.g., on each silicon chip). The calibration can be performed to achieve a selected (e.g., optimal) aging resolution that the TDC (e.g., TDC 113, TDC 813, or TDC 913) can provide.

As shown in FIG. 10, method 1000 can activities (e.g., operations) 1010, 1020, and 1030. At least part of method 1000 can be performed by an FSM (e.g., FSM 106) of digital aging sensor 101.

As shown in FIG. 10, activity 1010 of method 1000 can include switching delay lines 111 and 112 of digital aging sensor 101 to a ring-oscillator (RO) configuration. As described above, in the ring-oscillator configuration, the output node of delay line 111 can be connected to the input node of delay line 111. For example, in FIG. 1A, node 111" of delay line 111 can be connected to node 111' of delay line 111" in the ring-oscillator configuration. Similarly, the output node of delay line 112 can be connected to the input node of delay line 112. For example, in FIG. 1A, node 112" of delay line 112 can be connected to node 112' of delay line 112" in the ring-oscillator configuration.

Activity 1020 of method 1000 can include measuring the frequencies of the signals at delay lines 111 and 112 (e.g., the signals at the output nodes of the delay lines). Based on the length of the delay line and using a frequency counter (e.g., frequency counter 104 in FIG. 1A), the frequency can be measured with relatively high accuracy.

Activity 1030 of method 1000 can include tuning delay lines 111 and 112 to a selected length (e.g., optimal length). In activity 1030, the tuning can include adjusting (e.g., adding or subtracting) the number of delay elements (e.g., delay cells in FIG. 2) until a target frequency is met. The target frequencies for the different voltage intervals can be different for slow/typical and fast samples. They can be determined via simulations and are saved in separate tables for different types of silicon. For example, tables for slow, typical, and fast silicon can be defined. The target frequency (corresponding to the selected length of the delay line) includes a frequency that allows for a certain number of aging steps in the TDC (e.g., TDC 113, TDC 813, or TDC 913) over lifetime of the part (e.g., 5 years).

In some embodiments, one or more of the circuits or devices discussed in connection with FIG. 1 through FIG. 9 can perform the activities (e.g., operations) of method 1000 shown in FIG. 10 and the activities (e.g., operations) in the examples listed below.

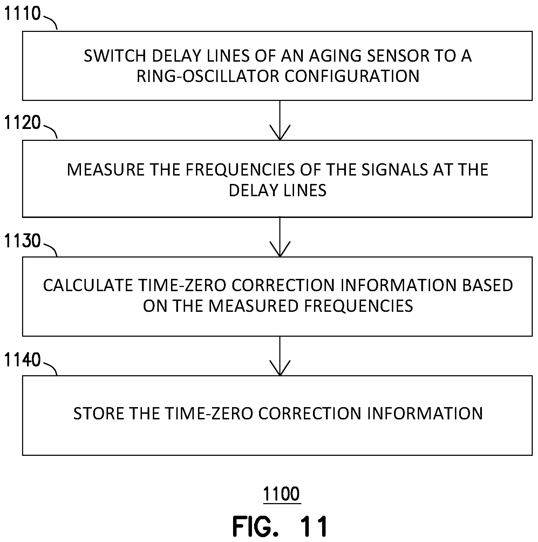

FIG. 11 is a flowchart showing an example method 1100 of another calibration for digital aging sensor 101, according to some embodiments described herein. The calibration in method 1100 can be called a time-zero calibration. Method 1100 can be performed to reduce (e.g., minimize) measurement error of digital aging sensor 101. During manufacturing, delay line 111 and delay line 112 may be subject to local random variation, which can impact yield. Local random variation can cause the ring-oscillator frequency (e.g., $R_1$ in equation (1) above)) of delay line 111 to be different from the ring-oscillator frequency (e.g., $R_2$ in equation (1) above)) of delay line 112, even though delay line 111 and delay line 112 have not yet been aged (e.g., the part is still new). This means that the term $[1 - (R_1 / R_2)]$ in equation (1) above is not zero, although it should be zero for an unaged (e.g., new) circuit. This can be called the time-zero error. This time-zero error can be determined per-part during manufacturing. Correction information for time-zero error can be saved (e.g., stored in fuses) in the part (e.g., device) where digital aging sensor 101 resides. The time-zero error correction information can be used by digital aging sensor 101 during operation of digital aging sensor 101.

In FIG. 11, method 1100 can be performed to determine (e.g., calculate) time-zero error and provide correction information to improve sensing operation (to minimize measurement error) of digital aging sensor 101. As shown in FIG. 11, method 1100 can include activities (e.g., operations) 1110, 1120, 1130, and 1140. At least part of method 1100 can be performed by an FSM (e.g., FSM 108) of digital aging sensor 101 (FIG. 1A).

As shown in FIG. 11, activity 1110 of method 1100 can include switching delay lines 111 and 112 of digital aging sensor 101 to a ring-oscillator configuration.

Activity 1120 can include measuring the frequencies of the signals at delay lines 111 and 112 (e.g., the signals at the output nodes of the delay lines). In activity 1120, frequencies (measured frequencies) of delay lines 111 and delay line 112 can include $R_1$ and $R_2$, respectively.

Activity 1130 can include calculating time-zero correction information Rc based on the measured frequencies. The calculation can be based on the equation Rc = [1 - ($R_1$ / $R_2$)].

Activity 1140 can include storing time-zero correction information Rc in digital aging sensor digital aging sensor 101. In an example, storing in activity 1140 can include storing time-zero correction information Rc in fuses in the part (e.g., device) where digital aging sensor 101 resides.

During sensing operation, digital aging sensor 101 can use time-zero correction information Rc in equation (2) below as part of measurement of total delay degradation $\Delta$t.

$$\Delta t = \left[ \left(1 - \frac{R_2}{R_1}\right) - \mathrm{Rc} + \left(\frac{\Delta tdc * TDCstepval}{2}\right) \right] * \mathrm{T}_1 \quad (2)$$

As described above, digital aging sensor 101 can be configured to measure total delay degradation $\Delta$t based on either equation (1) or equation (2). In an example, method 1100 (time-zero calibration) may be omitted (e.g., not performed). In this this example, digital aging sensor 101 can be configured to measure total delay degradation $\Delta$t based on equation (1). In another example, if method 1100 is performed, digital aging sensor 101 can be configured to measure total delay degradation $\Delta$t based on either equation (1) or equation (2). However, as described above, measuring total delay degradation $\Delta$t based on equation (2) (instead of equation (1)) can further improve sensing operation of digital aging sensor 101 in comparison.

In some embodiments, one or more of the circuits or devices discussed in connection with FIG. 1 through FIG. 9 can perform the activities (e.g., operations) of method 1100 shown in FIG. 11 and the activities (e.g., operations) in the examples listed below.

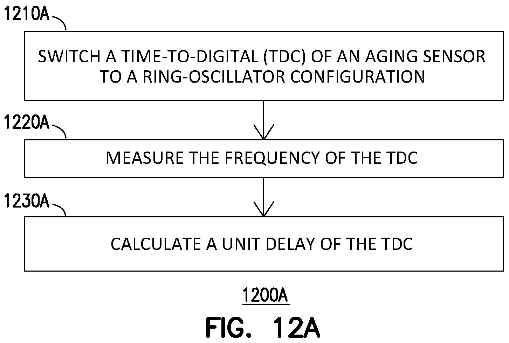

FIG. 12A is a flowchart showing an example method 1200A of another calibration for digital aging sensor 101, according to some embodiments described herein. The calibration in method 1200A can be called a TDC calibration. Method 1200A can be associated with FIG. 7A or FIG. 9. Method 1200A can be performed to further reduce measurement error in digital aging sensor 101. As shown in FIG. 12A, method 1200A can include activities 1210A, 1220A, and 1230A.

Activity 1210A can include switching a TDC path (e.g., the TDC path that includes node $113_1$' of FIG. 7A or FIG. 9) of a TDC to the ring-oscillator configuration. Activity 1220A can include measuring the frequency of the TDC in the ring-oscillator configuration. From the frequency, activity 1230A can include calculating the unit delay (which is equal to the TDC resolution). This delay unit delay can be used in the measured total delay degradation $\Delta$t to further improve measurement operation of digital aging sensor digital aging sensor 101.

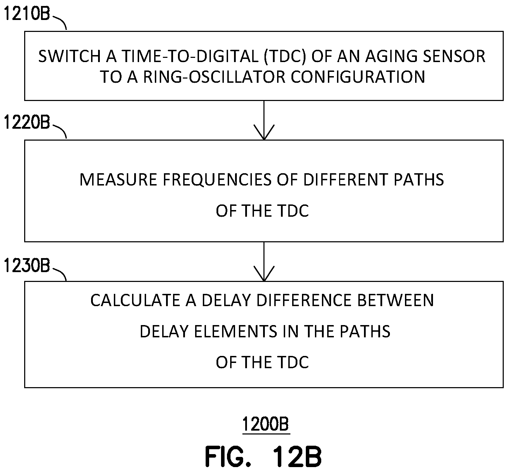

FIG. 12B is a flowchart showing an example method 1200B of another calibration for digital aging sensor 101, according to some embodiments described herein. The calibration in method 1200B can be called a TDC calibration. Method 1200B can be associated with FIG. 8. Method 1200B can be performed to further reduce measurement error in digital aging sensor 101. As shown in FIG. 12B, method 1200B can include activities 1210B, 1220B, and 1230B.

Activity 1210B of method 1200B can include switching a TDC (e.g., TDC 813) to a ring-oscillator configuration including switching an upper TDC path (e.g., path including node 113,' of FIG. 8) of the TDC and a lower TDC path (e.g., path including node $113_2$' of FIG. 8) of the TDC to the ring-oscillator configuration. Activity 1220B can include measuring the frequencies of the upper and lower TDC paths in the ring-oscillator configuration. From the frequencies of the upper and lower TDC paths, activity 1230B can include calculating a unit delay of each of the upper and lower TDC paths, and calculating a delay difference between the delay elements of the upper and lower TDC paths (e.g., unit delay of delay element 883 minus unit delay of delay element 733). This delay difference can be used in the measured total delay degradation $\Delta$t to further improve measurement operation of digital aging sensor digital aging sensor 101.

In some embodiments, one or more of the circuits or devices discussed in connection with FIG. 1 through FIG. 9 can perform the activities (e.g., operations) shown in methods 1200A and 1200B and the activities (e.g., operations) in the examples listed below.

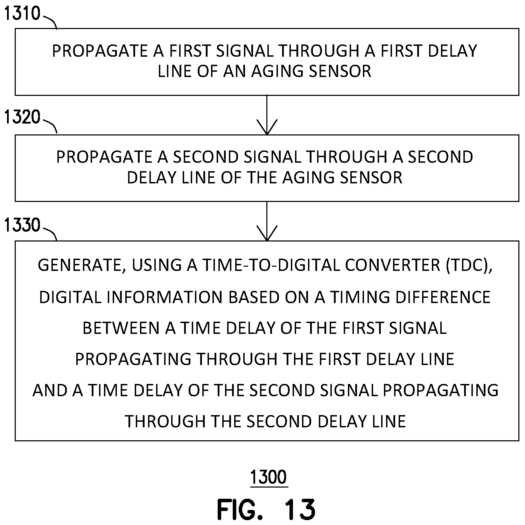

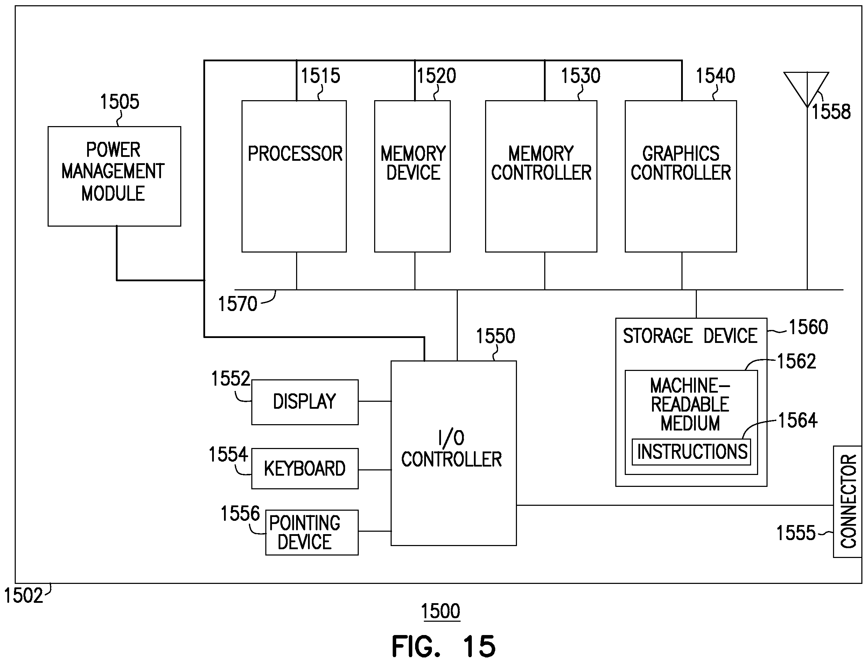

FIG. 13 is a flowchart showing an example method 1300 of operating an apparatus, according to some embodiments described herein. As shown in FIG. 13, method 1300 can include activities (e.g., operations) 1310, 1320, and 1330 that may be executed by an embedded controller or another processor of a computing device (e.g., hardware processor 1515 of machine 1500 shown in FIG. 15, which can include one or more of the circuits discussed in connection with FIG. 1 though FIG. 9).

Activity 1310 of method 1300 can include propagating a first signal through a first delay line (e.g., delay line 111) of an aging sensor. The aging sensor in method 1300 can include digital aging sensor 101 (FIG. 1A).

Activity 1310 can include propagating a second signal through a second delay line (e.g., delay line 112) of the aging sensor.

Activity 1310 can include generating, using a time-to-digital converter (TDC), digital information based on a time difference between a time delay of the first signal propagating through the first delay line and a time delay of the second signal propagating through the second delay line.

Method 1320 described above can include fewer or more activities relative to activities shown in FIG. 13. For example, method 1300 can include additional activities (e.g., operations) associated with the apparatus (e.g., apparatus 100) and/or system (e.g., system 1500) described with reference to FIG. 1A through FIG. 9 and FIG. 15. In some embodiments, method 1300 can further include activities in the examples listed below.

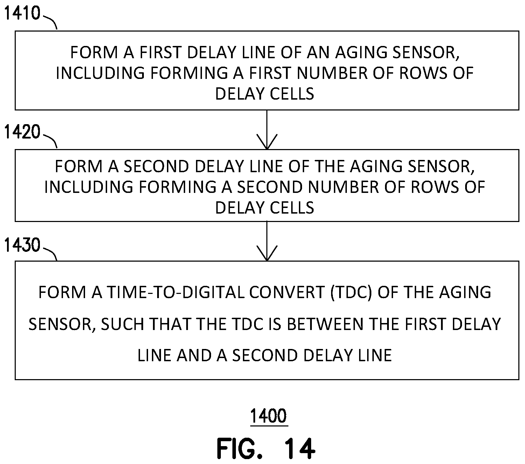

FIG. 14 is a flowchart showing an example method 1400 of forming an apparatus, according to some embodiments described herein. As shown in FIG. 14, method 1400 can include activity 1410, 1420, and 1430. The apparatus in method 1400 can include apparatus 100 including digital aging sensor 101.

Activity 1410 of method 1400 can include forming a first delay line of an aging sensor, including forming a first number of rows of delay cells. The aging sensor in method 1400 include digital aging sensor 101.

Activity 1420 of method 1400 can include forming a second delay line of the aging sensor, including forming a second number of rows of delay cells.

Activity 1410 of method 1400 includes forming a time-to-digital convert (TDC) of the aging sensor, such that the TDC is between the first delay line and a second delay line.

In some embodiments, method 1400 shown in FIG. 14 can include the activities in the examples listed below.

FIG. 15 shows an apparatus in the form of a system (e.g., electronic system) 1500, according to some embodiments described herein. System 1500 can be viewed as a machine. System (e.g., machine) 1500 can include or be included in a computer, a cellular phone, or other electronic systems. As shown in FIG. 15, system 1500 can include components (e.g., devices) located on a circuit board (e.g., PCB) 1502. The components can include processor (e.g., a hardware processor) 1515, memory device 1520, memory controller 1530, graphics controller 1540, I/O controller 1550, a display 1552, a keyboard 1554, a pointing device 1556, at least one antenna 1558, a storage device 1560, and a bus 1570. Bus 1570 can include conductive lines (e.g., metal-based traces on a circuit board 1502 where the components of system 1500 are located).

System 1500 can also include a power management module (e.g. power unit) 1505 to manage and provide power (e.g., from a battery, not shown) to other components of system 1500. Power management module 1505 can include or can be part of power control circuitry 130 of FIG. 1A.

System 1500 may be configured to perform one or more of the methods and/or operations described herein. At least one of the components of system 1500 (e.g., at least one of processor 1515, memory device 1520, memory controller 1530, graphics controller 1540, and I/O controller 1550) can include a device or functional circuitry (e.g., functional circuitry 120) described herein in which the device or functional circuitry can include circuitry and operation, as described above with reference to FIG. 1 through FIG. 13.

In FIG. 15, processor 1515 can include a general-purpose processor or an application specific integrated circuit (ASIC). Processor 1515 can include a central processing unit (CPU) and processing circuitry. Graphics controller 1540 can include a graphics processing unit (GPU) and processing circuitry. Memory device 1520 can include a dynamic random-access memory (DRAM) device, a static random-access memory (SRAM) device, a flash memory device, phase change memory, or a combination of these memory devices, or other types of memory. FIG. 15 shows an example where memory device 1520 is a stand-alone memory device separated from processor 1515. In an alternative structure, memory device 1520 and processor 1515 can be located on the same IC chip (e.g., a semiconductor die or IC die). In such an alternative structure, memory device 1520 is an embedded memory in processor 1515, such as embedded DRAM (eDRAM), embedded SRAM (eSRAM), embedded flash memory, or another type of embedded memory.

Storage device 1560 can include a drive unit (e.g., hard disk drive (HHD), solid-state drive (SSD), or another mass storage device). Storage device 1560 can include a machine-readable medium 1562 and processing circuitry. Machine-readable medium 1562 can store one or more sets of data structures or instructions 1564 (e.g., software) embodying or used by any one or more of the techniques or functions described herein. Instructions 1564 may also reside, completely or at least partially, within memory device 1520, memory controller 1530, processor 1515, or graphics controller 1540 during execution thereof by system (e.g., machine) 1500.

In an example, one of (or any combination of) processor 1515, memory device 1520, memory controller 1530, graphics controller 1540, and storage device 1560 may constitute machine-readable media. Non-limiting machine-readable medium examples may include solid-state memories and optical and magnetic media. Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

FIG. 15 shows machine-readable medium 1562 as a single medium as an example. However, the term "machine-readable medium" may include a single medium or multiple media (e.g., a centralized or distributed database, and/or associated caches and servers) configured to store instructions 1564. Further, the term "machine-readable medium" may include any medium that is capable of storing, encoding, or carrying instructions for execution by system 1500 and that causes system 1500 to perform any one or more of the techniques of the present disclosure, or that is capable of storing, encoding or carrying data structures used by or associated with such instructions. In some examples, machine-readable media may include non-transitory machine-readable media. In some examples, machine-readable media may include machine-readable media that is not a transitory propagating signal.

Display 1552 can include a liquid crystal display (LCD), a touchscreen (e.g., capacitive or resistive touchscreen), or another type of display. Pointing device 1556 can include a mouse, a stylus, or another type of pointing device. In some structures, system 1500 does not have to include a display. Thus, in such structures, display 1552 can be omitted from system 1500.

Antenna 1558 can include one or more directional or omnidirectional antennas, including, for example, dipole antennas, monopole antennas, patch antennas, loop antennas, microstrip antennas, or other types of antennas suitable for transmission of radio frequency (RF) signals. In some structures, system 1500 does not have to include an antenna. Thus, in such structures, antenna 1558 can be omitted from system 1500.

I/O controller 1550 can include a communication module for wired or wireless communication (e.g., communication through one or more antennas 1558). Such wireless communication may include communication in accordance with WiFi communication technique, Long Term Evolution Advanced (LTE-A) communication technique, or other communication techniques.

I/O controller 1550 can also include a module to allow system 1500 to communicate with other devices or systems in accordance with to one or more of the following standards or specifications (e.g., I/O standards or specifications), including Universal Serial Bus (USB), DisplayPort (DP), High-Definition Multimedia Interface (HDMI), Thunderbolt, Peripheral Component Interconnect Express (PCIe), Ethernet, and other specifications.

Connector 1555 can include terminals (e.g., pins) to allow system 1500 to receive a connection (e.g., an electrical connection) from an external device (or system). This may allow system 1500 to communicate (e.g., exchange information) with such a device (or system) through connector 1555. Connector 1555 and at least a portion of bus 1570 can include conductive lines that conform with at least one of USB, DP, HDMI, Thunderbolt, PCIe, Ethernet, and other specifications.

FIG. 15 shows the components (e.g., devices) of system 1500 arranged separately from each other as an example. For example, each of processor 1515, memory device 1520, memory controller 1530, graphics controller 1540, and I/O controller 1550 can be included in (e.g., formed in or formed on) a separate IC chip (e.g., separate semiconductor die or separate IC die). In some structures of system 1500, two or more components (e.g., processor 1515, memory device 1520, graphics controller 1540, and I/O controller 1550) of system 1500 can be included in (e.g., formed in or formed on) the same IC chip (e.g., same semiconductor die), forming a SoC. Alternatively, two or more components (e.g., processor 1515, memory device 1520, graphics controller 1540, and I/O controller 1550) of system 1500 can be included in the same package (e.g., same SiP).

The illustrations of the apparatuses (e.g., apparatuses apparatus 100 and system 1500) described above are intended to provide a general understanding of the structure of different embodiments and are not intended to provide a complete description of all the elements and features of an apparatus that might make use of the structures described herein.

Any of the components described above with reference to FIG. 1A through FIG. 15 can be implemented in a number of ways, including simulation via software. Thus, apparatuses (e.g., apparatuses apparatus 100 and system 1500) may all be characterized as "modules" (or "module") herein. Such modules may include hardware circuitry, single- and/or multi-processor circuits, memory circuits, software program modules and objects and/or firmware, and combinations thereof, as desired and/or as appropriate for particular implementations of various embodiments. For example, such modules may be included in a system operation simulation package, such as a software electrical signal simulation package, a power usage and ranges simulation package, a capacitance-inductance simulation package, a power/heat dissipation simulation package, a signal transmission-reception simulation package, and/or a combination of software and hardware used to operate or simulate the operation of various potential embodiments.

The apparatuses and methods described above can include or be included in high-speed computers, communication and signal processing circuitry, single- or multi-processor modules, single or multiple embedded processors, multicore processors, message information switches, and application-specific modules including multilayer, multichip modules. Such apparatuses may further be included as subcomponents within a variety of other apparatuses (e.g., electronic systems), such as televisions, cellular telephones, personal computers (e.g., laptop computers, desktop computers, handheld computers, tablet computers, etc.), workstations, radios, video players, audio players (e.g., MP3 (Motion Picture Experts Group, Audio Layer 3) players), vehicles, medical devices (e.g., heart monitor, blood pressure monitor, etc.), set top boxes, and others.

In the detailed description and the claims, the terms "first," "second," and "third," etc. are used merely as labels, and are not intended to impose numerical requirements on their objects.

In the detailed description and the claims, the term "on" used with respect to two or more elements (e.g., materials), one "on" the other, means at least some contact between the elements (e.g., between the materials). The term "over" means the elements (e.g., materials) are in close proximity, but possibly with one or more additional intervening elements (e.g., materials) such that contact is possible but not required. Neither "on" nor "over" implies any directionality as used herein unless stated as such.

In the detailed description and the claims, the term "adjacent" generally refers to a position of a thing being next to (e.g., either immediately next to or close to with one or more things between them) or adjoining another thing (e.g., abutting it or contacting it (e.g., directly coupled to) it).

In the detailed description and the claims, a list of items joined by the term "at least one of" can mean any combination of the listed items. For example, if items A and B are listed, then the phrase "at least one of A and B" means A only; B only; or A and B. In another example, if items A, B, and C are listed, then the phrase "at least one of A, B and C" means A only; B only; C only; A and B (excluding C); A and C (excluding B); B and C (excluding A); or all of A, B, and C. Item A can include a single element or multiple elements. Item B can include a single element or multiple elements. Item C can include a single element or multiple elements.

In the detailed description and the claims, a list of items joined by the term "one of" can mean only one of the list items. For example, if items A and B are listed, then the phrase "one of A and B" means A only (excluding B), or B only (excluding A). In another example, if items A, B, and C are listed, then the phrase "one of A, B and C" means A only; B only; or C only. Item A can include a single element or multiple elements. Item B can include a single element or multiple elements. Item C can include a single element or multiple elements.

Described implementations of the subject matter can include one or more features, alone or in combination as illustrated below by way of examples.

Example 1 is an electronic apparatus comprising a circuit including an output node to provide a signal, a first delay line including an input node coupled to the output node of the circuit, and an output node, a second delay line including an input node coupled to the output node of the circuit, and an output node, and time-to-digital converter (TDC) including a first input node coupled to the output node of the first delay line, and a second input node coupled to the output node of the second delay line.

In Example 2, the subject matter of Example 1 includes subject matter wherein the first delay line includes a first number of rows of delay cells, and the second delay line includes a second number of rows of delay cells.

In Example 3, the subject matter of Example 2 includes subject matter wherein the first number of rows of delay cells includes a delay cell, the delay cell including a first input node, a second input node, a first output node, and a second output node, a first circuit path coupled between the first input node and the first output node, a second circuit path coupled between the second input node and the second output node, and a third circuit path coupled between the first input node and the second output node.

In Example 4, the subject matter of any of Examples 1-3 includes subject matter wherein the first number of rows of delay cells is equal to the second number of rows of delay cells.

In Example 5, the subject matter of any of Examples 1-4 includes subject matter wherein the first delay line is located in a first circuit area of the apparatus, the second delay line is located in a second circuit area of the apparatus, and the TDC is located in a third circuit area of the apparatus, wherein the third circuit area is adjacent the first and second circuit areas.

In Example 6, the subject matter of any of Examples 1-5 includes a supply node, wherein the first delay line is configured to be disconnected from the supply node during a time interval, and the second delay line configured to be connected to the supply node during the time interval.

In Example 7, the subject matter of any of Examples 1-6 includes at least one logic gate coupled to the output node of the first delay line and the first input node of the TDC, and at least one logic gate coupled to the output node of the second delay line and the second input node of the TDC.

In Example 8, the subject matter of any of Examples 1-7 includes subject matter wherein the TDC includes a first flip-flop, a first delay element including an output node coupled to a data input node of the first flip-flop, a second flip-flop, and a second delay element including an output node coupled to a clock node of the first flip-flop and a data input node of the second flip-flop.

In Example 9, the subject matter of any of Examples 1-7 includes subject matter wherein the TDC includes a first delay element, and a second delay element coupled in series with first delay element, a third delay element, and a fourth delay element coupled in series with the third delay element, and a flip-flop including a data input node coupled to an output node of the first delay element and an input node of the second delay element, and a clock node coupled to an output node of the third delay element and an input node of the fourth delay element.

In Example 10, the subject matter of any of Examples 1-9 includes subject matter wherein the apparatus comprises a system on chip (SoC), the SoC including an integrated circuit (IC), the IC including the circuit, the first delay line, the second delay line, and the TDC.

In Example 11, the subject matter of Example 1 includes subject matter wherein the first delay line includes a first number of rows of logic gates, and the second delay line includes a second number of rows logic gates.

In Example 12, the subject matter of Example 1 includes subject matter wherein the first delay line includes a first number of inverter gates, and the second delay line include a second number of inverters, wherein the first number of inverters is equal to the second number of inverters.

In Example 13, the subject matter of Example 1 includes subject matter wherein the first delay line includes a first number of logic NAND gates, and the second delay line include a second number of logic NAND gates, wherein the first number of logic NAND gates is equal to the second number of logic NAND gates.

In Example 14, the subject matter of Example 1 includes subject matter wherein the first delay line includes a first number of logic NOR gates, and the second delay line include a second number of logic NOR gates, wherein the first number of logic NOR gates is equal to the second number of logic NOR gates.

In Example 15, the subject matter of Example 1 includes subject matter wherein the first delay line includes a first number of rows of logic gates, and the second delay line includes a second number of rows of logic gates, and the first number of rows of logic gates is equal to a second number of rows of logic gates.

In Example 16, the subject matter of any of Examples 1-15 includes subject matter wherein at least one of the first and second delay lines include a cell, the cell including a first input node, and a first output node, and a first logic gate coupled between the first input node and the second input node, and a second input node, and a second output node, and a second logic gate coupled between the second input node and the second output nodes.

In Example 17, the subject matter of any of Examples 1-15 includes subject matter wherein at least one of the first and second delay lines include a cell, the cell including a first input node, and a first output node, and a first logic gate coupled between the first input node and the second input node, a second input node, and a second output node, and a second logic gate coupled between the second input node and the second output node, and a circuit path coupled between the first input node and the second output node.

Example 18 is an electronic apparatus comprising an aging sensor, the aging sensor including a circuit including an output node to provide a signal, a first delay line to propagate the signal through the first delay line and provide a first output signal, a second delay line to propagate the signal through the second delay line and provide a second output, and a time-to-digital converter (TDC) to generate a digital information based at least on a time delay difference between the first output signal and the second output signal.

In Example 19, the subject matter of Example 18 includes subject matter wherein the first delay line includes a first row of a first type of logic gates, and a second row of a second type of logic gates, and the second delay line includes a third row of the first type of logic gates, and a fourth row of the second type of logic gates.

In Example 20, the subject matter of Example 19 includes subject matter wherein the first number of rows of logic gates include a first row of logic gates, the second number of rows of logic gates include a second row of logic gates, and wherein the first row of logic gates includes a same number of logic gates as the second row of logic gates.

In Example 21, the subject matter of Example 18 includes subject matter wherein the TDC includes a first delay element, and a second delay element coupled in series with first delay element, a first flip-flop including a data input node coupled to an input node of the first delay element, and a second flip-flop including a data input node coupled to an output node of the second delay element.

In Example 22, the subject matter of any of Examples 18-21 includes subject matter wherein the aging sensor includes a first mode, a second mode, and a supply node, and wherein the first delay line is configured to be connected to the supply node during the first mode and disconnected from the supply node during the second mode, and the second delay line is configured to be connected to the supply node during the first mode and connected to the supply node during the second mode.

In Example 23, the subject matter of any of Examples 18-22 includes subject matter wherein the apparatus comprises a system in a package (SiP), the SiP including the aging sensor.

In Example 24, the subject matter of any of Examples 18-23 includes a connector, wherein the apparatus comprises an integrated circuit (IC) coupled to the connector, the IC including the aging sensor, and wherein the connector conforms with at least one of Universal Serial Bus (USB), High-Definition Multimedia Interface (HDMI), Thunderbolt, Peripheral Component Interconnect Express (PCIe), and Ethernet specifications.

In Example 25, the subject matter of any of Examples 18-24 includes subject matter wherein the aging sensor includes a node to receive a voltage, a first switch coupled between node and a supply node of the first delay line, a second switch coupled between the node and a supply node of second delay line, wherein the first switch is configured to turn off during a mode of the aging sensor, and the second switch is configured to turn on during the mode of the aging sensor.

In Example 26, the subject matter of Example 25 includes subject matter wherein the mode is a first mode, and wherein the first switch is configured to turn on during a second mode of the aging sensor, and the second switch is configured to turn on during the second mode of the aging sensor.

In Example 27, the subject matter of Example 18 includes subject matter wherein the first delay line includes a number of delay cells, the number of delay cells includes a combination of inverters, NAND gates, and NOR gates.

In Example 28, the subject matter of Example 27 includes subject matter wherein the second delay line includes a number of delay cells, the number of delay cells includes a combination of inverters, NAND gates, and NOR gates.

In Example 29, the subject matter of any of Examples 18-24 includes subject matter wherein the TDC is to generate the digital information based at least on a time delay difference between a rising edge of the first output signal and a rising edge of the second output signal.

In Example 30, the subject matter of any of Examples 18-24 includes subject matter wherein the TDC is to generate the digital information based at least on a time delay difference between a falling edge of the first output signal and a falling edge of the second output signal.

Example 31 is method comprising propagating a first signal through a first delay line of an aging sensor, propagating a second signal through a second delay line of the aging sensor, and generating, using a time-to-digital converter (TDC), digital information based on a difference of a time delay of the first signal propagating through the first delay line and a time delay of the second signal propagating through the second delay line.

In Example 32, the subject matter of Example 31 includes performing a calibration operation to adjust a length of the first delay line and a length of the second delay line.

In Example 33, the subject matter of Example 31 includes performing a calibration operation to provide correction information for a frequency difference associated with the first delay line and the second delay line.

In Example 34, the subject matter of Example 31 includes subject matter wherein propagating the first signal through the first delay line includes propagating the first signal through at least one delay cell among delay cells of a first row of the first delay line, propagating the first signal through at least one delay cell among delay cells of a second row of the first delay line, and propagating the first signal through at least one delay cell among delay cells of a third row of the first delay line.

In Example 35, the subject matter of Example 34 wherein propagating the second signal through the second delay line includes propagating the second signal through at least one delay cell among delay cells of a first row of the second delay line, propagating the second signal through at least one delay cell among delay cells of a second row of the second delay line, and propagating the second signal through at least one delay cell among delay cells of a third row of the second delay line.

In Example 36, the subject matter of Example 31 includes turning on a first switch coupled between the first delay line and a supply node during a first time interval, turning on a second switch coupled between the second delay line and the supply node during the first time interval, turning off the first switch during a second time interval, and turning on the second switch during the second time interval.

In Example 37, the subject matter of Example 31 includes providing power to the first and second delay lines during propagating the first signal through the first delay line and propagating the second signal through the second delay line, disconnecting the power from the first delay line after propagating the signal through the first delay line, and keeping the second delay line connected to the power while the power is disconnected from the first delay line.

In Example 38, the subject matter of Example 31 includes turning on a first switch coupled between a supply node of the first delay line and a supply voltage during propagating the first signal through the first delay line, turning on a second switch coupled between a supply node of the second delay line and the supply voltage during propagating the second signal through the second delay line, turning off the first switch after propagating the first signal through the first delay line, and keeping the second switch turned on while the first switch is turned off.

In Example 39, the subject matter of Example 31 includes subject matter wherein the first and second signals are based a rising edge of a signal.

In Example 40, the subject matter of Example 31 includes subject matter wherein the first and second signals are based a falling edge of a signal.

In Example 41, the subject matter of Example 31 further comprising switching the TDC a ring-oscillator configuration, measuring a frequency of TDC in the R ring-oscillator configuration, and calculating a unit delay associated with the TDC based on the frequency.

In Example 42, the subject matter of Example 31 further comprising switching a first path and a second path of the TDC a ring-oscillator configuration, measuring first delay throughput time through a delay element of the first path, measuring second delay throughput time through a delay element of the second path, and calculating a delay difference between the first delay throughput time and the second first delay throughput time.

Example 43 is a method comprising forming a first delay line of an aging sensor, including forming a first number of delay cells, forming a second delay line of the aging sensor, including forming a second number of delay cells, and forming a time-to-digital convert (TDC) of the aging sensor coupled to the first delay line and a second delay line.

In Example 44, the subject matter of Example 43 includes subject matter wherein forming the first number of delay cells includes forming a first row of logic gates, forming a second row of logic gates, and forming a third row of logic gates, and forming the second number of delay cells includes forming a first additional row of logic gates, forming a second additional row of logic gates, and forming a third additional row of logic gates.

In Example 45, the subject matter of Example 43 includes subject matter wherein one of the first row of logic gates, the second row of logic gates, and the third row of logic gates has a same type of logic gate as one of the first additional row of logic gates, the second additional row of logic gates, and the third additional row of logic gates.

In Example 46, the subject matter of Example 43 includes subject matter wherein one of the first row of logic gates, the second row of logic gates, and the third row of logic gates has a different type of logic gate from one of the first additional row of logic gates, the second additional row of logic gates, and the third additional row of logic gates.

Example 47 at least one machine-readable medium including instructions that, when executed by processing circuitry, cause the processing circuitry to perform operations to implement any of Examples 1-46.

Example 48 apparatus comprising means to implement any of Examples 1-46.

Example 49 is system to implement any of Examples 1-46.

Example 50 is method to implement any of Examples 1-46.

The above description and the drawings illustrate some embodiments of the inventive subject matter to enable those skilled in the art to practice the embodiments of the inventive subject matter. Other embodiments may incorporate structural, logical, electrical, process, and other changes. Examples merely typify possible variations. Portions and features of some embodiments may be included in, or substituted for, those of others. Many other embodiments will be apparent to those of skill in the art upon reading and understanding the above description.

The Abstract is provided to allow the reader to ascertain the nature and gist of the technical disclosure. It is submitted with the understanding that it will not be used to limit or interpret the scope or meaning of the claims. The following claims are hereby incorporated into the detailed description, with each claim standing on its own as a separate embodiment.

**Claims**

1. An electronic apparatus comprising:

   a circuit including an output node to provide a signal;
   a first delay line including an input node coupled to the output node of the circuit, and an output node;
   a second delay line including an input node coupled to the output node of the circuit, and an output node; and
   time-to-digital converter (TDC) including a first input node coupled to the output node of the first delay line, and a second input node coupled to the output node of the second delay line.

2. The apparatus of claim 1, wherein:

   the first delay line includes a first number of rows of delay cells; and
   the second delay line includes a second number of rows of delay cells.

3. The apparatus of claim 2, wherein the first number of rows of delay cells includes a delay cell, the delay cell including:

   a first input node, a second input node, a first output node, and a second output node;
   a first circuit path coupled between the first input node and the first output node;
   a second circuit path coupled between the second input node and the second output node; and
   a third circuit path coupled between the first input node and the second output node.

4. The apparatus of any of claims 2-3, wherein the first number of rows of delay cells is equal to the second number of rows of delay cells.

5. The apparatus of any of claims 1-3, wherein at least one of the first and second delay lines include a delay cell, the delay cell including:

   a first input node, and a first output node, and a first logic gate coupled between the first input node and the second input node; and

and a second input node, and a second output node, and a second logic gate coupled between the second input node and the second output node.

6.  The apparatus of any of claims 1-3, further comprising a supply node, wherein the first delay line is configured to be disconnected from the supply node during a time interval, and the second delay line configured to be connected to the supply node during the time interval.

7.  The apparatus of any of claims 1-3, further comprising:

    at least one logic gate coupled to the output node of the first delay line and the first input node of the TDC; and
    at least one logic gate coupled to the output node of the second delay line and the second input node of the TDC.

8.  The apparatus of any of claims 1-3, wherein the TDC includes:

    a first flip-flop;
    a first delay element including an output node coupled to a data input node of the first flip-flop;
    a second flip-flop; and
    a second delay element including an output node coupled to a clock node of the first flip-flop and a data input node of the second flip-flop.

9.  The apparatus of any of claims 1-3, wherein the TDC includes:

    a first delay element, and a second delay element coupled in series with first delay element;
    a third delay element, and a fourth delay element coupled in series with the third delay element; and
    a flip-flop including a data input node coupled to an output node of the first delay element and an input node of the second delay element, and a clock node coupled to an output node of the third delay element and an input node of the fourth delay element.

10. The apparatus of any of claims 1-3, wherein the apparatus comprises a system on chip (SoC), the SoC including an integrated circuit (IC), the IC including the circuit, the first delay line, the second delay line, and the TDC.

11. The apparatus of any of claims 1-3, wherein the apparatus comprises a system in a package (SiP), the SiP including the circuit, the first delay line, the second delay line, and the TDC.

12. The apparatus of any of claims 1-3, further comprising a connector, wherein the apparatus comprises an integrated circuit (IC) coupled to the connector, the IC including the aging sensor, and wherein the connector conforms with at least one of Universal Serial Bus (USB), High-Definition Multimedia Interface (HDMI), Thunderbolt, Peripheral Component Interconnect Express (PCIe), or Ethernet specifications.

13. A method of operating an electronic apparatus, comprising:

    propagating a first signal through a first delay line of an aging sensor;
    propagating a second signal through a second delay line of the aging sensor; and
    generating, using a time-to-digital converter (TDC), digital information based on a difference of a time delay of the first signal propagating through the first delay line and a time delay of the second signal propagating through the second delay line.

14. The method of claim 13, further comprising:
    performing a calibration operation to adjust a length of the first delay line and a length of the second delay line.

15. The method of claim 13, further comprising:
    performing a calibration operation to provide correction information for a frequency difference associated with the first delay line and the second delay line.

FIG. 1A

100

EP 4 625 821 A1

$D1_R$

$DL1_{IN}$ $111'_R$ $111''_R$ $DL1_{OUT}$

$D2_R$

$DL2_{IN}$ $112'_R$ $112''_R$ $DL2_{OUT}$

$\triangle t_R$

t0 **FIG. 1B** t1 t2

$D1_F$

$DL1_{IN}$ $111'_F$ $111''_F$ $DL1_{OUT}$

$D2_F$

$DL2_{IN}$ $112'_F$ $112''_F$ $DL2_{OUT}$

$\triangle t_F$

t3 **FIG. 1C** t4 t5

FIG. 2

FIG. 3

100

FIG. 4A

FIG. 4B

FIG. 4C

FIG. 4D

FIG. 4E

FIG. 4F

EP 4 625 821 A1

FIG. 5A

FIG. 5B

FIG. 6

EP 4 625 821 A1

DL1$_{OUT}$ ⌐ 113'$_1$

t

733

733

733

733

733

d

723 D Q

723 D Q

723 D Q

723 D Q

DL2$_{OUT}$ ⌐ 113'$_2$

t+Δt$_R$

113

113"

0

0

1

1

CODE

**FIG. 7A**

| REGISTER VALUE (CODE) | Δt$_R$ VALUE |
|---|---|
| 000000... | $0 < \Delta t_R < d$ |
| 100000... | $d < \Delta t_R < 2*d$ |
| 110000... | $2*d < \Delta t_R < 3*d$ |
| 111000... | $3*d < \Delta t_R < 4*d$ |
| ⋮ | ⋮ |

**FIG. 7B**

713A

723 733

723 733

723 733

**FIG. 7C**

FIG. 8

FIG. 9

1010 — SWITCH DELAY LINES OF AN AGING SENSOR TO A RING-OSCILLATOR CONFIGURATION

1020 — MEASURE THE FREQUENCIES OF THE SIGNALS AT THE DELAY LINES

1030 — TUNE THE DELAY LINE TO A SELECTED LENGTH

1000

FIG. 10

1110

SWITCH DELAY LINES OF AN AGING SENSOR TO A
RING-OSCILLATOR CONFIGURATION

1120

MEASURE THE FREQUENCIES OF THE SIGNALS AT THE
DELAY LINES

1130

CALCULATE TIME-ZERO CORRECTION INFORMATION BASED
ON THE MEASURED FREQUENCIES

1140

STORE THE TIME-ZERO CORRECTION INFORMATION

1100

FIG.  11

1210A

SWITCH A TIME-TO-DIGITAL (TDC) OF AN AGING SENSOR
TO A RING-OSCILLATOR CONFIGURATION

1220A

MEASURE THE FREQUENCY OF THE TDC

1230A

CALCULATE A UNIT DELAY OF THE TDC

1200A

FIG. 12A

1210B

SWITCH A TIME-TO-DIGITAL (TDC) OF AN AGING SENSOR
TO A RING-OSCILLATOR CONFIGURATION

1220B

MEASURE FREQUENCIES OF DIFFERENT PATHS

OF THE TDC

1230B

CALCULATE A DELAY DIFFERENCE BETWEEN

DELAY ELEMENTS IN THE PATHS

OF THE TDC

1200B

FIG. 12B

1310

┌─────────────────────────────────────────────┐
│ PROPAGATE A FIRST SIGNAL THROUGH A FIRST DELAY │
│         LINE OF AN AGING SENSOR               │
└─────────────────────────────────────────────┘

1320

┌─────────────────────────────────────────────┐
│ PROPAGATE A SECOND SIGNAL THROUGH A SECOND    │
│      DELAY LINE OF THE AGING SENSOR           │
└─────────────────────────────────────────────┘

1330

┌─────────────────────────────────────────────┐
│ GENERATE, USING A TIME-TO-DIGITAL CONVERTER (TDC), │
│ DIGITAL INFORMATION BASED ON A TIMING DIFFERENCE   │
│ BETWEEN A TIME DELAY OF THE FIRST SIGNAL           │
│ PROPAGATING THROUGH THE FIRST DELAY LINE           │
│ AND A TIME DELAY OF THE SECOND SIGNAL PROPAGATING  │
│ THROUGH THE SECOND DELAY LINE                      │
└─────────────────────────────────────────────┘

1300

FIG. 13

FORM A FIRST DELAY LINE OF AN AGING SENSOR, INCLUDING FORMING A FIRST NUMBER OF ROWS OF DELAY CELLS — 1410

FORM A SECOND DELAY LINE OF THE AGING SENSOR, INCLUDING FORMING A SECOND NUMBER OF ROWS OF DELAY CELLS — 1420

FORM A TIME-TO-DIGITAL CONVERT (TDC) OF THE AGING SENSOR, SUCH THAT THE TDC IS BETWEEN THE FIRST DELAY LINE AND A SECOND DELAY LINE — 1430

1400

FIG. 14

FIG. 15

## EUROPEAN SEARCH REPORT

**Application Number**

EP 25 16 3985

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MIN CHEN ET AL: "Asymmetric Aging and Workload Sensitive Bias Temperature Instability Sensors", IEEE DESIGN & TEST OF COMPUTERS, IEEE SERVICE CENTER, NEW YORK, NY, US, vol. 29, no. 5, 1 October 2012 (2012-10-01), pages 18-26, XP011488904, ISSN: 0740-7475, DOI: 10.1109/MDT.2012.2210381 | 1-5,7, 10-15 | INV. H03K19/003 G01R31/28 ADD. G04F10/00 |
| Y | * figure 7 * | 8,9 | |
| A | | 6 | |
| | - - - - - | | |
| Y | US 2013/293281 A1 (BAUMANN THOMAS [DE] ET AL) 7 November 2013 (2013-11-07) * figures 13-22 * | 8,9 | |
| | - - - - - | | |

**TECHNICAL FIELDS SEARCHED (IPC)**

H03K
G01R
G04G
G04F

The present search report has been drawn up for all claims

| Place of search | Date of completion of the search | Examiner |
|---|---|---|
| Munich | 31 July 2025 | Santos, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 3985

This annex lists the patent family members relating to the patent documents cited in the above-mentioned European search report.
The members are as contained in the European Patent Office EDP file on
The European Patent Office is in no way liable for these particulars which are merely given for the purpose of information.

31-07-2025

| Patent document cited in search report | Publication date | Patent family member(s) | Publication date |
|---|---|---|---|
| US 2013293281 A1 | 07-11-2013 | CN 203588103 U | 07-05-2014 |
| | | DE 102013104536 A1 | 23-10-2014 |
| | | US 2013293281 A1 | 07-11-2013 |

EPO FORM P0459

For more details about this annex : see Official Journal of the European Patent Office, No. 12/82